# EUROPEAN PATENT SPECIFICATION

(11) **EP 4 661 630 B1**
(45) Date of publication and mention of the grant of the patent: **25.11.2026**
(21) Application number: 25180127.0
(22) Date of filing: 02.06.2025
(51) Int. Cl.: H10F 19/90, H10F 77/20

(54) **SOLAR CELL AND PHOTOVOLTAIC MODULE**
SOLARZELLE UND FOTOVOLTAISCHES MODUL
CELLULE SOLAIRE ET MODULE PHOTOVOLTAÏQUE

(30) Priority: 03.06.2024 CN 202421258254 U; 17.06.2024 CN 202410780857; 05.11.2024 CN 202411572227
(43) Date of publication of application: 10.12.2025
(60) Divisional application: 26163520.5 / 4 730 964
(73) Proprietor: Longi Green Energy Technology Co., Ltd., Xi'an, Shaanxi 710100 (CN)
(72) Inventor: Li, Zhenguo, Shaanxi, 710100 (CN); Chen, Jun, Shaanxi, 710100 (CN); Wang, Xiaofei, Shaanxi, 710100 (CN); Yang, Dongsheng, Shaanxi, 710100 (CN); Chen, Weiqiang, Shaanxi, 710100 (CN); Zhang, Huang, Shaanxi, 710100 (CN)
(74) Representative: Grünecker Patent- und Rechtsanwälte PartG mbB

(56) References cited:
- CN-A- 116 964 755
- CN-A- 117 352 570
- CN-U- 215 988 784
- US-A1- 2013 104 956
- US-A1- 2019 074 395

## Description

### CROSS-REFERENCE TO RELATED APPLICATIONS

The present application claims priorities to Chinese Patent Application No. 202410780857.3, entitled "SOLAR CELL AND PHOTOVOLTAIC MODULE" and filed with the China National Intellectual Property Administration on June 17, 2024, Chinese Patent Application No. 202421258254.9, entitled "PHOTOVOLTAIC MODULE AND PHOTOVOLTAIC SYSTEM" and filed with the China National Intellectual Property Administration on June 3, 2024, and Chinese Patent Application No. 202411572227.3, entitled "SOLAR CELL AND PHOTOVOLTAIC MODULE" and filed with the China National Intellectual Property Administration on November 5, 2024.

### TECHNICAL FIELD

The present application relates to the field of photovoltaic technologies, and specifically, to a solar cell and a photovoltaic module.

### BACKGROUND

A solar cell has a front surface facing the sunlight and a back surface back to the sunlight. In a back contact solar cell, a positive electrode grid line and a negative electrode grid line of the solar cell are both disposed on a back surface of the solar cell, so that the positive electrode grid line and the negative electrode grid line do not block a front surface of the solar cell, thereby improving a photoelectric conversion efficiency of the solar cell.

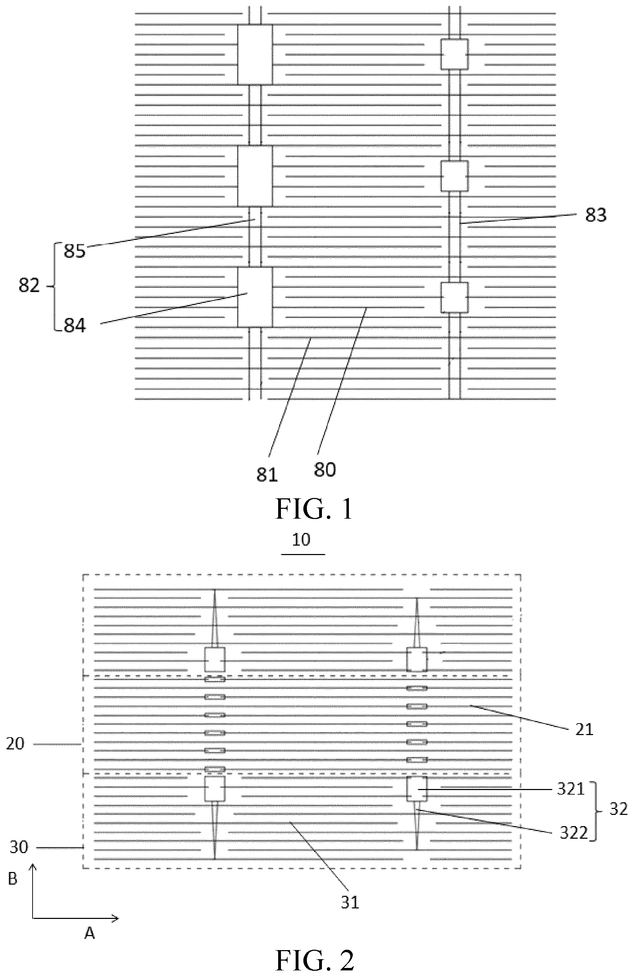

As shown in FIG. 1, in the related art, positive electrode fingers 80 and negative electrode fingers 81 extending along a first direction and alternately arranged along a second direction are disposed on the back surface of the back contact solar cell, to collect currents generated by the solar cell by using the positive electrode fingers 80 and the negative electrode fingers 81. Positive electrode busbars 82 and negative electrode busbars 83 extending along the second direction and arranged at intervals along the first direction are further disposed on the back surface of the solar cell. The positive electrode busbars 82 and the negative electrode busbars 83 all include soldering points 84 alternately arranged along the second direction and connection lines 85 connected to the soldering points 84. Soldering strips extend along the second direction and are connected to the soldering points 84. Currents are transmitted to the soldering strips via the soldering points 84, so that the currents are collected and transmitted by using the soldering strips.

Using the positive electrode busbars 82 as an example, in a region in which the soldering points 84 of the positive electrode busbars 82 are located, the positive electrode fingers 80 are connected to the soldering points 84 of the positive electrode busbars 82, and currents collected by the positive electrode fingers 80 may be collected by using the soldering points 84 of the positive electrode busbars 82. The negative electrode fingers 81 and the soldering points 84 of the positive electrode busbars 82 are disposed at intervals, to avoid a short circuit in the solar cell. However, in a region in which the connection lines 85 of the positive electrode busbars 82 are located, the positive electrode fingers 80 are connected to the connection lines 85 of the positive electrode busbars 82. The currents collected by the positive electrode fingers 80 are transmitted to the soldering points 84 of the positive electrode busbars 82 via the connection lines 85 of the positive electrode busbars 82, and then the currents are transmitted to the corresponding soldering strips via the soldering points 84 of the positive electrode busbars 82, so that the currents are collected and transmitted. The negative electrode fingers 81 and the connection lines 85 of the positive electrode busbars 82 are disposed at intervals, to avoid a short circuit in the solar cell. It should be noted that a principle of the negative electrode busbars 83 is the same as that of the positive electrode busbars 82, and details are not described herein again.

However, the foregoing setting causes a long current transmission distance and a large internal loss. As a result, the photoelectric conversion efficiency of the solar cell is affected.

The preamble of claim 1 is known for example from document CN 116964755 A.

### SUMMARY

The present invention is related to a solar cell according to claim and a photovoltaic module according to claim 8, to resolve or at least partially resolve a problem of a long current transmission distance and a large internal loss that affect a photoelectric conversion efficiency of a solar cell in the related art.

To resolve the foregoing technical problem, the present application is implemented as follows:
The present application discloses a solar cell. The solar cell includes a solar cell body, where the solar cell body includes a substrate, a doped region formed on the substrate, and a passivation layer covering the doped region; and a first pattern region, where the first pattern region is disposed at the passivation layer. The first pattern region includes a plurality of first fingers extending along a first direction and arranged at intervals along a second direction. Each of the first fingers includes a plurality of first connection segments disposed at intervals along the first direction and second connection segments connected between two adjacent first connection segments. The second direction intersects with the first direction. A plurality of second connection segments are arranged at intervals along the second direction, and at least one of the first connection segments is disposed between two adjacent second connection segments. The first connection segments burn through the passivation layer and are electrically connected to the doped region, and the second connection segments do not burn through the passivation layer.

Through the foregoing setting, the first connection segments may collect currents generated by the solar cell body, and the second connection segments may directly collect the currents collected by the first connection segments connected to the second connection segments. Therefore, a current transmission distance can be reduced, an internal loss of the solar cell can be reduced, and a photoelectric conversion efficiency of the solar cell can be improved.

### BRIEF DESCRIPTION OF THE DRAWINGS

FIG. 1 is a schematic diagram of a partial structure of a solar cell in the related art;
FIG. 2 is a top view of a solar cell according to an embodiment of the present application;
FIG. 3 is a top view of a first pattern region according to an embodiment of the present application;
FIG. 4 is a partial top view of a first pattern region according to an embodiment of the present application;
FIG. 5 is a top view of a second pattern region according to an embodiment of the present application;
FIG. 6 is a schematic diagram 1 of a structure of a solar cell according to an embodiment of the present application;
FIG. 7 is a schematic diagram 2 of a structure of a solar cell according to an embodiment of the present application;
FIG. 8 is a schematic diagram 3 of a structure of a solar cell according to an embodiment of the present application;
FIG. 9 is a schematic diagram 4 of a structure of a solar cell according to an embodiment of the present application;
FIG. 10 is a schematic diagram of a structure of a first connection block and a first sub-finger according to an embodiment of the present application;
FIG. 11 is a schematic diagram of a structure of a first grid-line pattern region according to an embodiment of the present application;
FIG. 12 is a cross-section view of a part A-A in FIG. 11;
FIG. 13 is a partial enlarged view of a part B in FIG. 12;
FIG. 14 is a partial cross-section view 1 of a solar cell according to another embodiment of the present application;
FIG. 15 is a partial cross-section view 2 of a solar cell according to another embodiment of the present application;
FIG. 16 is a schematic diagram of a structure of a metal particles according to an embodiment of the present application;
FIG. 17 is a partial enlarged view of a part C in FIG. 3;
FIG. 18 is a cross-section view of a part D-D in FIG. 17;
FIG. 19 is a top view of a photovoltaic module in a first pattern region according to an embodiment of the present application;
FIG. 20 is a section view of a photovoltaic module in a first pattern region according to an embodiment of the present application;
FIG. 21 is a partial top view of a photovoltaic module in a first pattern region according to an embodiment of the present application;
FIG. 22 is a section view of the photovoltaic module in FIG. 21 along a direction C1-C2;
FIG. 23 is a schematic diagram 1 of a partial structure of a photovoltaic module according to an embodiment of the present application;
FIG. 24 is a schematic diagram 2 of a partial structure of a photovoltaic module according to an embodiment of the present application;
FIG. 25 is a partial enlarged view of a part E in FIG. 24; and
FIG. 26 is a cross-section view of a part F-F in FIG. 25.

Reference numerals:
10: solar cell body; 11: substrate; 12: doped region; 121: first doped region; 122: second doped region; 14: passivation layer; 13: oxide layer; 123: isolation region;
20: first pattern region; 21: first finger; 211: first connection segment; 212: second connection segment; 213: metal particles; 214: first sub-finger; 215: second sub-finger; 2121: first connection block; 2122: second connection block; 2141: first finger segment; 2142: first disconnected portion; 2151: second finger segment; 2152: second disconnected portion;
30: second pattern region; 31: second finger; 311: third sub-finger; 312: fourth sub-finger; 32: collecting segment; 321: collecting point; 322: end line;
40: insulating layer; 41: insulating strip; 411: first insulating strip; 412: second insulating strip;
50: electrical connector; 51: first electrical connector; 52: second electrical connector;
60: first engaging layer; 61: first engaging portion;
70: second engaging layer;
A: first direction; B: second direction;
80: positive electrode finger; 81: negative electrode finger; 82: positive electrode busbar; 83: negative electrode busbar; 84: soldering point; and 85: connection line.

### DETAILED DESCRIPTION

The technical solutions in embodiments of the present application are clearly and completely described below with reference to the accompanying drawings of the embodiments of the present application. It is clear that the described embodiments are a part of the embodiments of the present application, rather than all of the embodiments. Based on the embodiments of the present application, all other embodiments obtained by a person of ordinary skill in the art without creative efforts shall fall within the scope of the present application.

It should be understood that "one embodiment" or "an embodiment" mentioned throughout this specification means that specific features, structures, or characteristics related to the embodiment are included in at least one embodiment of the present application. Therefore, "in one embodiment" or "in an embodiment" appearing throughout this specification does not necessarily refer to a same embodiment. In addition, these specific features, structures, or characteristics may be combined in one or more embodiments in any suitable manner.

As shown in FIG. 2 to FIG. 5, an embodiment of the present application discloses a solar cell. The solar cell includes a solar cell body 10, where the solar cell body 10 includes a substrate, a doped region formed on the substrate, and a passivation layer covering the doped region; and a first pattern region 20, where the first pattern region 20 is disposed at the passivation layer. The first pattern region 20 includes a plurality of first fingers 21 extending along a first direction A and arranged at intervals along a second direction B. Each of the first fingers 21 includes a plurality of first connection segments 211 disposed at intervals along the first direction A and second connection segments 212 connected between two adjacent first connection segments 211. The second direction B intersects with the first direction A. A plurality of second connection segments 212 are arranged at intervals along the second direction B, and at least one of the first connection segments 211 is disposed between two adjacent second connection segments 212. The first connection segments 211 burn through the passivation layer and are electrically connected to the doped region, and the second connection segments 212 do not burn through the passivation layer.

As shown in FIG. 2 to FIG. 5, the solar cell includes the solar cell body 10 and the first pattern region 20 disposed at the passivation layer. The solar cell body 10 is a core component of the solar cell, and can convert solar energy into electrical energy. The solar cell body 10 has a light receiving surface facing the sunlight, that is, a front surface. The solar cell body 10 also has a back-light surface facing away from the sunlight, that is, a back surface. The first pattern region 20 in this embodiment of the present application may be disposed on the front surface of the solar cell body 10, or may be disposed on the back surface of the solar cell body 10. This is not specifically limited in the present application. Related descriptions are provided below by using an example in which the first pattern region 20 is disposed on the back surface of the solar cell body 10, that is, the solar cell is a back contact solar cell.

It should be noted that the solar cell body 10 in some embodiments includes the substrate, the doped region formed on the substrate, and the passivation layer covering the doped region. The first pattern region 20 is disposed at the passivation layer, and currents generated at a position corresponding to the solar cell body 10 is collected and collected by using the first pattern region 20.

As shown in FIG. 2 to FIG. 5, the first pattern region 20 is disposed on the back surface of the solar cell body 10, to prevent blocking the front surface of the solar cell body 10 and affecting a photoelectric conversion efficiency of the solar cell body 10. The first pattern region 20 includes the plurality of first fingers 21 extending along the first direction A and arranged at intervals along the second direction B, to collect and collect, by using the first fingers 21, currents generated by the solar cell body 10. The first pattern region 20 is a region occupied by the plurality of first fingers 21 on the back surface of the solar cell body 10.

It should be noted that, in an embodiment, the solar cell body 10 may have a rectangular structure, a square structure, or a quasi-rectangular structure. The quasi-rectangular structure refers to that the solar cell having the rectangular structure has a round chamfer or a square chamfer, and the round chamfer or the square chamfer is directly connected to one side edge of the solar cell body 10. Certainly, the solar cell body 10 may alternatively have another shape. In this embodiment of the present application, a specific structure of the solar cell body 10 is not excessively limited. Related descriptions are provided below by using an example in which the solar cell body 10 has a rectangular structure.

It should be noted that, in an embodiment, if the first direction A is a length direction of the solar cell body 10, the second direction B is a width direction of the solar cell body 10. If the first direction A is the width direction of the solar cell body 10, the second direction B is the length direction of the solar cell body 10. This is not specifically limited in the present application.

It should be noted that burning through in this embodiment of the present application refers to that, after a grid line is sintered, solidified, or shaped, a metal material of the grid line passes through the passivation layer and enters the doped region, to form electrical contact. A material of the grid line may include a glass material, and the glass material corrodes the passivation layer (for example, an insulating material such as aluminum oxide, silicon nitride, or silicon oxide), so that the metal material of the grid line can enter the doped region. In an embodiment, the metal material of the grid line and a material of the doped region may form a metal silicide or a metal crystal.

As shown in FIG. 2 to FIG. 5, each of the first fingers 21 includes the plurality of first connection segments 211 disposed at intervals along the first direction A and the second connection segments 212 connected between two adjacent first connection segments 211. Each of the first connection segments 211 and each of the second connection segments 212 are both strip-shaped structures extending along the first direction A. The first connection segments 211 burn through the passivation layer and are electrically connected to the doped region, so that the currents generated by the solar cell body 10 can be collected. The second connection segments 212 located between two adjacent first connection segments 211 do not burn through the passivation layer, and the currents collected by the first connection segments 211 are directly collected by using the second connection segments 212, so that a current transmission distance is reduced, an internal loss of the solar cell is reduced, and a photoelectric conversion efficiency of the solar cell is improved.

Further, in a photovoltaic module, the second connection segments 212 are connected to electrical connectors 50, to transmit the currents collected by the second connection segments 212 to an external circuit via the electrical connectors 50. Soldering is required between the second connection segments 212 and the electrical connectors 50. If the second connection segments 212 can burn through the passivation layer and be electrically connected to the doped region, the soldering easily affects the doped region. As a result, a thermal damage is caused, and a current collection efficiency of the photovoltaic module is reduced.

As shown in FIG. 2 to FIG. 5, the plurality of second connection segments 212 are arranged at intervals along the second direction B, and the at least one of the first connection segments 211 is disposed between the two adjacent second connection segments 212. It may be understood that the plurality of second connection segments 212 arranged at intervals along the second direction B are first fingers 21 having a same polarity, and the first connection segment 211 located between the two adjacent second connection segments 212 has a polarity opposite to that of the adjacent second connection segments 212. For example, when the plurality of second connection segments 212 arranged at intervals along the second direction B are first positive electrode fingers 21, the first connection segment 211 located between the two adjacent second connection segments 212 is a first negative electrode finger 21. When the plurality of second connection segments 212 arranged at intervals along the second direction B are first negative electrode fingers 21, the first connection segment 211 located between the two adjacent second connection segments 212 is a first positive electrode finger 21.

In this embodiment of the present application, the plurality of second connection segments 212 are arranged at intervals along the second direction B, and the first connection segments 211 is disposed between the two adjacent second connection segments 212, so that the electrical connectors 50 are extended along the second direction B and are connected to the plurality of second connection segments 212 having the same polarity. In this way, the currents generated by the solar cell body 10 are collected and transmitted.

It should be noted that no busbar is disposed on the surface of the solar cell disclosed in some embodiments of the present application, in other words, the solar cell disclosed in this embodiment of the present application is a solar cell with no busbar. In some other embodiments, a part of busbars may be partially disposed on the surface of the solar cell, or the busbar is disposed below some electrical connectors, but there is no complete busbar structure below at least a part of electrical connectors. It may be understood that, the electrical connectors 50 are directly connected to the second connection segments 212 of the first fingers 21, to collect and transmit the currents collected by the first fingers 21.

In the solar cell disclosed in this embodiment of the present application, the first connection segments 211 may collect the currents generated by the solar cell body 10, and the second connection segments 212 may directly collect the currents collected by the first connection segments 211 connected to the second connection segments 212. Therefore, the current transmission distance can be reduced, the internal loss of the solar cell can be reduced, and the photoelectric conversion efficiency of the solar cell can be improved.

In an embodiment, as shown in FIG. 2 to FIG. 5, a length of each of the first connection segments 211 is greater than a length of each of the second connection segments 212 along the first direction A; and/or a width of each of the second connection segments 212 is greater than a width of each of the first connection segments 211 along the second direction B.

As shown in FIG. 2 to FIG. 5, the length of each of the first connection segments 211 is set to be greater than the length of each of the second connection segments 212 along the first direction A. Therefore, the first connection segments 211 are longer than the second connection segments 212, so that the currents generated by the solar cell body 10 can be better collected, and the photoelectric conversion efficiency of the solar cell can be improved.

As shown in FIG. 2 to FIG. 5, the width of each of the second connection segments 212 is set to be greater than the width of each of the first connection segments 211 along the second direction B. Therefore, the second connection segments 212 are more reliably connected to the electrical connectors 50, so that the currents collected by the second connection segments 212 can be transmitted to the external circuit via the electrical connectors 50.

In an embodiment, a polarity of each of the second connection segments 212 is opposite to a polarity of an adjacent first connection segment 211 along the second direction B.

As shown in FIG. 2 to FIG. 5, the plurality of second connection segments 212 are arranged at intervals along the second direction B, and the at least one of the first connection segments 211 is disposed between the two adjacent second connection segments 212. Along the second direction B, when the polarity of each of the second connection segments 212 is positive, the polarity of the first connection segment 211 adjacent to the second connection segment 212 is negative. When the polarity of each of the second connection segments 212 is negative, the polarity of the first connection segment 211 adjacent to the second connection segment 212 is positive. In other words, the polarity of each of the second connection segments 212 is opposite to the polarity of the adjacent first connection segment 211 along the second direction B.

The polarity of each of the second connection segments 212 is set to be opposite to the polarity of the adjacent first connection segment 211 along the second direction B. Therefore, the electrical connectors 50 are extended along the second direction B and are connected to the plurality of second connection segments 212 having the same polarity. In this way, the currents generated by the solar cell body 10 are collected and transmitted.

In an embodiment, as shown in FIG. 2 to FIG. 5, the solar cell disclosed in this embodiment of the present application further includes: a second pattern region 30. The second pattern region 30 is disposed at the passivation layer, and is disposed adjacent to the first pattern region 20 along the second direction B. The second pattern region 30 includes a plurality of second fingers 31 extending along the first direction A and arranged at intervals along the second direction B. The second pattern region 30 further includes collecting segments 32, and the collecting segments 32 extend along the second direction B. A part of the second fingers 31 are connected to the collecting segments 32.

As shown in FIG. 2 to FIG. 5, the second pattern region 30 is also disposed at the passivation layer, and the second pattern region 30 is disposed adjacent to the first pattern region 20 along the second direction B. In addition, in comparison with the first pattern region 20, the second pattern region 30 is located in a region closer to a side edge of the solar cell body 10.

The second pattern region 30 includes the plurality of second fingers 31 extending along the first direction A and arranged at intervals along the second direction B. The second fingers 31 may burn through the passivation layer and be electrically connected to the doped region, to collect the currents generated by the solar cell body 10.

As shown in FIG. 2 to FIG. 5, the second pattern region 30 further includes the collecting segments 32, and the collecting segments 32 extend along the second direction B. The collecting segments 32 do not burn through the passivation layer. The collecting segments 32 are connected to a part of the second fingers 31, to collect currents collected by the part of the second fingers 31. In addition, gaps exist between the collecting segments 32 and the other part of the second fingers 31, to avoid a short-circuit phenomenon occurring on the solar cell. In other words, the other part of the second fingers 31 are in an open state at positions of the collecting segments 32.

It should be noted that the second fingers 31 include second positive electrode fingers and second negative electrode fingers, and the second positive electrode fingers and the second negative electrode fingers are alternately arranged along the second direction B. There are a plurality of collecting segments 32 in this embodiment of the present application. The plurality of collecting segments 32 all extend along the second direction B and are arranged at intervals along the first direction A. When one of the collecting segments 32 is connected to the second positive electrode finger, a gap exists between the collecting segment 32 and the second negative electrode finger, in other words, the second negative electrode finger is in an open state at a position of the collecting segment 32. Another collecting segment 32 adjacent to the collecting segment 32 may be connected to the second negative electrode finger, and a gap exists between the another collecting segment 32 and the second positive electrode finger, in other words, the second positive electrode finger is in an open state at a position of the another collecting segment 32. In this way, currents collected by the second positive electrode fingers and the second negative electrode fingers are collected by using the plurality of collecting segments 32.

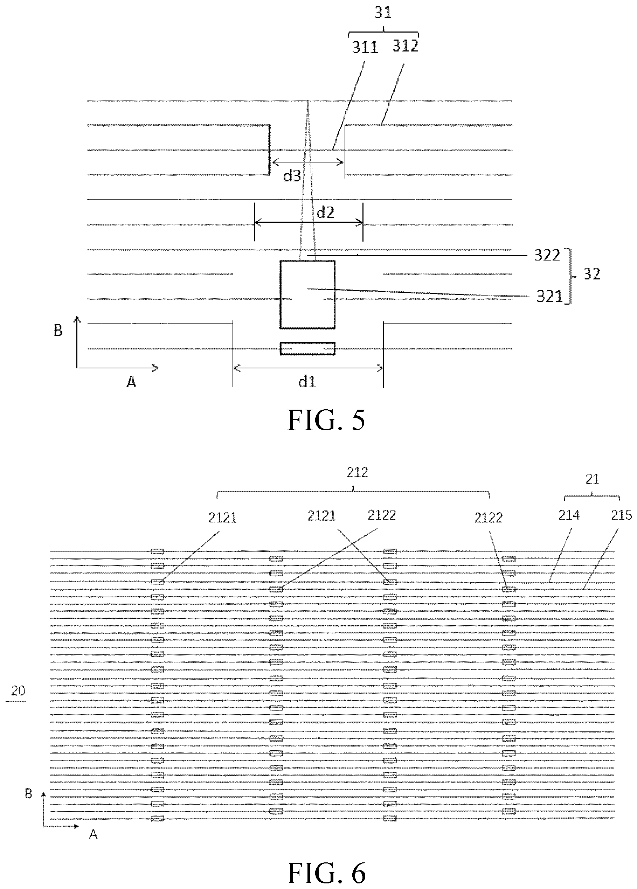

In an embodiment, as shown in FIG. 2 and FIG. 5, the collecting segments 32 include collecting points 321 and end lines 322 connected to the collecting points 321. The end lines 322 are disposed at positions away from the first pattern region 20 in the second pattern region 30. The plurality of second fingers 31 include a plurality of third sub-fingers 311 and a plurality of fourth sub-fingers 312 alternately arranged along the second direction B. The plurality of third sub-fingers 311 are connected to the collecting points 321 or the end lines 322, and gaps exist between the plurality of fourth sub-fingers 312 and the collecting points 321 or the end lines 322.

As shown in FIG. 2 and FIG. 5, the collecting segments 32 include the collecting points 321 and the end lines 322 connected to the collecting points 321. The collecting points 321 and the end lines 322 are arranged along the second direction B. Along the second direction B, the collecting points 321 are located in a region close to the first pattern region 20 in the second pattern region 30, and the end lines 322 are located in a region away from the first pattern region 20 in the second pattern region 30.

The plurality of second fingers 31 include the plurality of third sub-fingers 311 and the plurality of fourth sub-fingers 312 alternately arranged along the second direction B. The third sub-fingers 311 and the fourth sub-fingers 312 have different polarities. It may be understood that, when the third sub-fingers 311 are second positive electrode fingers, the fourth sub-fingers 312 are second negative electrode fingers. When the third sub-fingers 311 are second negative electrode fingers, the fourth sub-fingers 312 are second positive electrode fingers.

As shown in FIG. 2 to FIG. 5, the plurality of third sub-fingers 311 are connected to the collecting points 321 or the end lines 322, to collect, by using the collecting points 321 and/or the end lines 322, currents collected by the plurality of third sub-fingers 311. However, gaps exist between the plurality of fourth sub-fingers 312 and the collecting points 321 and the end lines 322, in other words, the plurality of fourth sub-fingers 312 are in an open state at positions of the collecting points 321 and the end lines 322, to avoid a short-circuit phenomenon occurring on the solar cell.

In an embodiment, as shown in FIG. 5, the plurality of second fingers 31 include a plurality of third sub-fingers 311 (which may be, for example, the second positive electrode fingers) and a plurality of fourth sub-fingers 312 (which may correspondingly be, for example, second negative electrode fingers) alternately arranged along the second direction B. The plurality of third sub-fingers 311 are connected to the collecting segments 32, and gaps exist between the plurality of fourth sub-fingers 312 and the collecting segments 32. A first gap, a second gap, and a third gap disposed along the first direction A exist between fourth sub-fingers 312 located on two sides of each of the collecting segments 32. The first gap, the second gap, and the third gap are gradually away from the first pattern region 20 along the second direction B. A width of the first gap is d₁, a width of the second gap is d₂, and a width of the third gap is d₃ along the first direction A. d₁, d₂, and d₃ satisfy d₁>d₂>d₃>0, or satisfy d₁>d₂=d₃>0.

Through the foregoing setting, positions at which the collecting segments 32 are directly electrically connected to the electrical connectors 50 can have a larger width, to avoid excessively concentrated currents. The collecting segments 32 are narrower at positions far away from the positions at which the collecting segments 32 are electrically connected to the electrical connectors 50, to reduce an amount of materials used in the collecting segments 32, and ensure that a length of the second fingers 31 is larger. Therefore, the photoelectric conversion efficiency of the solar cell is further improved.

In addition, through the foregoing setting, the plurality of fourth sub-fingers 312 can better collect the currents generated by the solar cell body 10, to improve the photoelectric conversion efficiency of the solar cell. In addition, a risk of a short circuit in the solar cell can further be avoided.

In an embodiment, as shown in FIG. 5, the collecting segments 32 include collecting points 321 and end lines 322 connected to the collecting points 321. The end lines 322 are connected to a side that is of the collecting points 321 and that is away from the first pattern region 20. The collecting points 321 pass through the first gap, and the end lines 322 pass through the second gap and the third gap.

As shown in FIG. 5, the collecting segments 32 include the collecting points 321 and the end lines 322 connected to the collecting points 321. The collecting points 321 and the end lines 322 are arranged along the second direction B. Along the second direction B, the collecting points 321 are located on a side close to the first pattern region 20 of the second pattern region 30, and the end lines 322 are located on a side away from the first pattern region 20 of the second pattern region 30.

The collecting points 321 are set to pass through the first gap, and the end lines 322 are set to pass through the second gap and the third gap, so that there is a larger width between the collecting points 321 and a part of the fourth sub-fingers 312, to avoid excessively concentrated currents. A distance between the end lines 322 and the part of the fourth sub-fingers 312 is small, to reduce an amount of materials used in the end lines 322, and ensure that the length of the second fingers 31 is larger. Therefore, the photoelectric conversion efficiency of the solar cell is further improved.

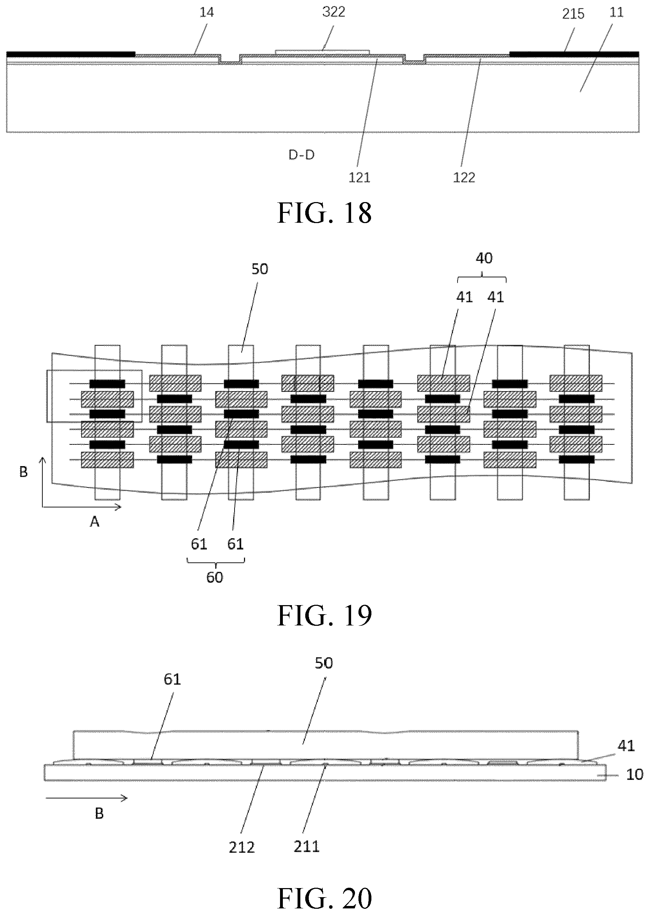

In an embodiment, as shown in FIG. 19 to FIG. 22, the solar cell disclosed in this embodiment of the present application further includes an insulating layer 40. The insulating layer 40 includes a plurality of insulating strips 41 extending along the first direction A and arranged at intervals along the second direction B. Each of the insulating strips 41 covers a part that is of one of the first connection segments 211 and that is located between two adjacent second connection segments 212.

As shown in FIG. 19 to FIG. 22, the insulating layer 40 includes the plurality of insulating strips 41 extending along the first direction A and arranged at intervals along the second direction B. Each of the insulating strips 41 may be a strip-shaped structure extending along the first direction A. For example, when being observed in a top view, the insulating strip is in a shape of a rectangle or a quasi-rectangular structure shape, a shape of an ellipse or a quasi-ellipse shape, a shape that is narrow at two ends and width in the middle, or another possible shape. In this embodiment of the present application, each of the insulating strips 41 covers a surface that is of one of the first connection segments 211 and that is away from the solar cell body 10, and is located between the two adjacent second connection segments 212, so that the electrical connection between the first connection segments 211 and the electrical connectors 50 is blocked by using the insulating strips 41, to avoid a short-circuit phenomenon occurring on the solar cell.

It should be noted that the insulating strips 41 have insulation, and may have flexibility. For example, the insulating strips 41 are insulating adhesive. In a processing process of the solar cell, the insulating adhesive is printed, in a manner of screen printing, on surfaces that are of the first connection segments 211 and that are away from the solar cell body 10, and the insulating adhesive is located between the two adjacent second connection segments 212, to cover the insulating adhesive on the surfaces that are of the first connection segments 211 and that are away from the solar cell body 10.

Certainly, the foregoing are merely examples of a specific material and a processing manner of the insulating strips 41, and are not intended to limit the present application. During actual application, a skilled person may alternatively set a specific material and a processing manner of the insulating strips 41 according to a requirement. Specifically, the insulating strips 41 may be doped inorganic materials, for example, silicon nitride or silicon oxide, or may be organic materials, for example, resin-type materials.

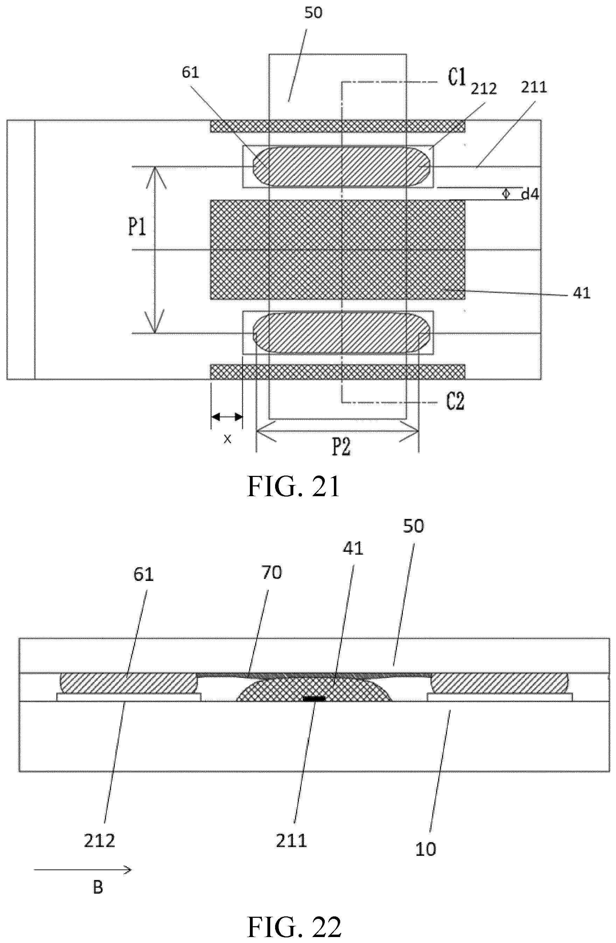

In an embodiment, as shown in FIG. 21, along the second direction B, a distance between a side edge that is of each of the second connection segments 212 and that is close to an adjacent insulating strip 41 and a side edge that is of the adjacent insulating strip 41 and that is close to the second connection segment 212 is d₄, and d₄≥40 µm is satisfied.

As shown in FIG. 21, along the second direction B, the distance between the side edge that is of each of the second connection segments 212 and that is close to the adjacent insulating strip 41 and the side edge that is of the adjacent insulating strip 41 and that is close to the second connection segment 212 is set to d₄, and d₄≥40 µm is satisfied. Therefore, a case in which the insulating strips 41 block the second connection segments 212 and affect reliability of the connection between the second connection segments 212 and the electrical connectors 50, and further affect the photoelectric conversion efficiency of the solar cell, is avoided. Further, through the foregoing setting, processing of the solar cell is facilitated, and a processing efficiency and a processing yield rate of the solar cell are improved.

For example, along the second direction B, the distance d₄ between the side edge that is of each of the second connection segments 212 and that is close to the adjacent insulating strip 41 and the side edge that is of the adjacent insulating strip 41 and that is close to the second connection segment 212 may be set to 40 µm, 42 µm, 45 µm, 47 µm, 50 µm, 52 µm, or 55 µm.

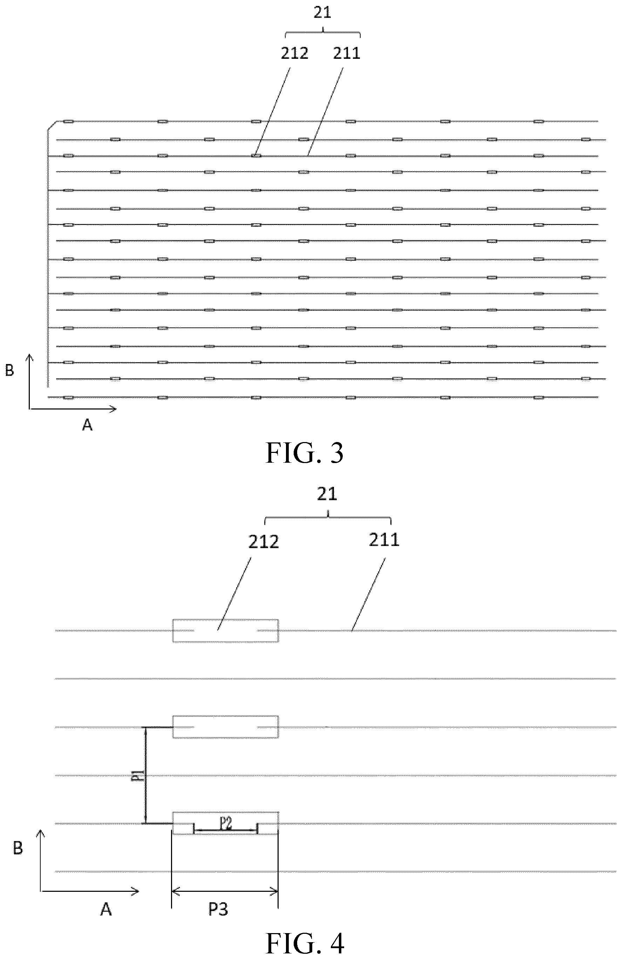

In an embodiment, as shown in FIG. 4 and FIG. 21, each of the first connection segments 211 has a first projection and each of the second connection segments 212 has a second projection in a plane on which the solar cell body 10 is located, and the first projection at least partially falls within the second projection. A distance between two adjacent first sub-fingers 214 having a same polarity along the second direction B is P₁, a distance by which two first connection segments 211 connected to a same second connection segment 212 are separated along the first direction A is P₂, and P₂≤P₁ is satisfied.

As shown in FIG. 4 and FIG. 21, each of the first connection segments 211 has the first projection and each of the second connection segments 212 has the second projection in the plane on which the solar cell body 10 is located, and the first projection is set to at least partially fall within the second projection, to ensure that the first connection segments 211 are at least partially connected to the second connection segments 212. Therefore, the currents collected by the first connection segments 211 can be collected by using the second connection segments 212.

As shown in FIG. 2, the first pattern region 20 includes the plurality of first sub-fingers 214 extending along the first direction A and alternately arranged along the second direction B. The plurality of first sub-fingers 214 include a plurality of first positive electrode fingers and a plurality of first negative electrode fingers, and the plurality of first positive electrode fingers and the plurality of first negative electrode fingers are alternately arranged along the second direction B. In other words, along the second direction B, two first fingers adjacent to each of the first positive electrode fingers are first negative electrode fingers, and two first fingers adjacent to each of the first negative electrode fingers are first positive electrode fingers.

As shown in FIG. 4 and FIG. 21, the distance between the two adjacent first sub-fingers 214 having the same polarity along the second direction B is P₁. The distance may be a distance between two adjacent first positive electrode fingers, or may be a distance between two adjacent first negative electrode fingers. Related descriptions are provided below by using an example in which the distance is the distance between two adjacent first positive electrode fingers.

It should be noted that, in the two adjacent first positive electrode fingers, along the second direction B, the distance may be a distance between two adjacent first connection segments 211, or may be a distance between two adjacent second connection segments 212. When the distance is the distance between the two adjacent second connection segments 212, the distance may be a distance between a side edge of one of the second connection segments 212 close to the other second connection segment 212 and a side edge of the other second connection segment 212 close to the second connection segment 212. Alternatively, the distance may be a distance between a middle position of one of the second connection segments 212 and a middle position of the other second connection segment 212 along the second direction B. When the distance is the distance between the two adjacent first connection segments 211, a specific length of the distance may be calculated with reference to the manner of the second connection segments 212. Details are not described herein again.

As shown in FIG. 4 and FIG. 21, the distance P₁ between the two adjacent first fingers 21 having the same polarity along the second direction B is set to be greater than or equal to the distance P₂ by which the two first connection segments 211 connected to the same second connection segment 212 are separated along the first direction A. Therefore, currents generated in regions on two sides of each of the first fingers 21 in the solar cell body 10 along the second direction B can be better collected, to improve the photoelectric conversion efficiency of the solar cell.

Further, from a perspective of a collection distance, P₁ in this embodiment of the present application represents a better collection distance in the second direction B, and P₂ represents a better collection distance in the first direction A. P₂ is set to be less than or equal to P₁, to ensure that ends of first fingers 21 located on two sides of P₂ can collect currents in a region covered by the second connection segments 212.

In an embodiment, a length of the second connection segments 212 along the first direction A is P₃, and P₂<P₃ is satisfied; and/or P₂>0 mm, and 0.5 mm≤P₁≤1.5 mm. In the embodiment of FIG. 4, P₂ is enabled to be less than or equal to P₁, and P₂ is greater than 0 mm, for example, P₂ ranges from 0.2 mm to 1.2 mm. In this way, a consumption amount of slurry of the first connection segment 211 can be effectively reduced, and carrier collection efficiency in both a transverse direction (an extension direction of the first fingers 21) and a longitudinal direction (a direction perpendicular to the extension direction of the first fingers 21) can be ensured.

In this embodiment of the present application, the distance P₂ by which the two first connection segments 211 connected to the same second connection segment 212 are separated along the first direction A is set to be less than the length P₃ of the second connection segments 212. Therefore, the first connection segments 211 are at least partially disposed in a region in which the second connection segments 212 are located, and the first connection segments 211 can burn through a passivation layer of the region in which the second connection segments 212 are located, to collect currents generated in a doped region corresponding to the region in which the second connection segments 212 are located, so that the photoelectric conversion efficiency of the solar cell is further improved.

In this embodiment of the present application, the distance P₂ by which the two first connection segments 211 connected to the same second connection segment 212 are separated along the first direction A is set to be greater than 0 mm. For example, the distance P₂ by which the two first connection segments 211 connected to the same second connection segment 212 are separated along the first direction A may be set to 0 mm, 0.2 mm, 0.5 mm, 0.8 mm, 1.0 mm, or 1.2 mm.

In this embodiment of the present application, the distance P₁ between the two adjacent first fingers 21 having the same polarity along the second direction B is set to be greater than or equal to 0.5 mm and less than or equal to 1.5 mm. For example, the distance P₁ between the two adjacent first fingers 21 having the same polarity along the second direction B may be set to 0.5 mm, 0.8 mm, 1.0 mm, 1.2 mm, or 1.5 mm.

Certainly, the foregoing are merely examples of the specific lengths of P₁ and P₂ in this embodiment of the present application, and are not intended to limit the present application. During actual application, a skilled person may set the specific lengths of P₁ and P₂ according to a requirement, provided that P₂≤P₁ is satisfied.

In an embodiment, as shown in FIG. 6 to FIG. 18, the solar cell in this embodiment includes the solar cell body 10. The solar cell body 10 includes a first surface (which may be, for example, a light receiving surface or a back surface) and a second surface (which may be, for example, a light receiving surface or a front surface) that are disposed opposite to each other. Along a direction from the second surface to the first surface, the solar cell body 10 includes the substrate 11, the doped region 12, and the passivation layer 14 that are sequentially stacked; the first pattern region 20, where the first pattern region 20 is disposed on the first surface, the first pattern region 20 includes the first fingers 21, and the first fingers 21 include the first sub-fingers 214 and second sub-fingers 215 extending along the first direction A and alternately arranged along the second direction B; and the second connection segments 212, where the second connection segments 212 include a plurality of first connection blocks 2121 overlapping the first sub-fingers 214 and a plurality of second connection blocks 2122 overlapping the second sub-fingers 215. The plurality of first connection blocks 2121 and the first sub-fingers 214 are stacked, and the plurality of second connection blocks 2122 and the second sub-fingers 215 are stacked. A part that is of the first sub-fingers 214 and that is stacked with the first connection blocks 2121 passes through the passivation layer 14 and is in contact with the doped region 12. The second direction B intersects with the first direction A. Polarities of the first sub-fingers 214 are opposite to polarities of the second sub-fingers 215. For example, when the first sub-fingers 214 are positive first fingers, the second sub-fingers 215 are negative first fingers, or vice versa. A doping type of a doped region 12 below a first sub-finger 214 and a second sub-finger 215 that correspond to each other corresponds to polarities of the first sub-finger 214 and the second sub-finger 215 that correspond to each other.

It should be noted that the first sub-fingers 214 and the second sub-fingers 215 are continuous along the first direction A at the first connection blocks 2121 and the second connection blocks 2122 that are stacked with the first sub-fingers 214 and the second sub-fingers 215, similar to the embodiment of FIG. 4 in which the plurality of connection segments 211 are not disconnected at locations of the second connection segments 212, that is, P₂ of the plurality of connection segments 211 at the locations of the second connection segments 212 is 0. In an embodiment, the doped region 12 may be a doped region formed through in-situ doping on the substrate 11, or may be an additional layer, for example, a polysilicon layer, formed on the back surface of the substrate 11 in a manner such as deposition. When the doped region 12 is the additional layer, an oxide layer 13 may further be provided between the doped region 12 and the substrate 11, and the oxide layer 13 may be silicon oxide. The passivation layer 14 may be a single-layer or multi-layer structure of at least one of dielectric layers such as silicon nitride, silicon oxide, aluminum oxide, and silicon oxynitride.

In an embodiment, the plurality of first connection blocks 2121 and the plurality of second connection blocks 2122 are arranged in an array, and are arranged in rows in the first direction A and are arranged in columns in the second direction B. In the first direction A, a plurality of rows of first connection blocks 2121 and a plurality of rows of second connection blocks 2122 are sequentially alternately arranged at intervals. In the second direction B, a plurality of columns of first connection blocks 2121 and a plurality of columns of second connection blocks 2122 are sequentially alternately arranged at intervals.

In some embodiments, the first connection blocks 2121 and the second connection blocks 2122 are both made by using non-burn-through slurry and are conductive. For example, the first connection blocks 2121 and the second connection blocks 2122 may be made by using non-burn-through silver slurry, non-burn-through copper slurry, or another conductive non-burn-through metal material. Certainly, in this embodiment of the present application, specific materials of the first connection blocks 2121 and the second connection blocks 2122 are not excessively limited, and may be selected by a skilled person based on a requirement during actual application.

In an embodiment, a metal material of the first connection blocks 2121 and the second connection blocks 2122 is the same as a metal material of the first sub-fingers 214 and the second sub-fingers 215, and may be, for example, at least one of silver or copper.

In this embodiment of the present application, the plurality of first connection blocks 2121 and the first sub-fingers 214 are stacked. The part that is of the first sub-fingers 214 and that is stacked with the first connection blocks 2121 passes through the passivation layer 14 and is in contact with the doped region 12. The first connection blocks 2121 are used to protect the part that is of the first sub-fingers 214 and that is stacked with the first connection blocks 2121, to reduce a degree of a thermal impact on the first sub-fingers 214 when first electrical connectors 51 are welded to the first sub-fingers 214, so as to avoid a damage to the substrate 11 when the first sub-fingers 214 pass through the doped region 12 and reach the substrate 11, and ensure photoelectric conversion efficiency of the photovoltaic module.

The first sub-fingers 214 in this embodiment of the present application may be made of burn-through metal slurry and are conductive. The first sub-fingers 214 may burn through the passivation layer 14, and is in direct contact with the doped region 12, to form a metal silicide. The metal silicide may enable the first sub-fingers 214 to be in Ohmic contact with the doped region 12, so as to collect a current generated by the substrate 11. For example, the first sub-fingers 214 are made of burn-through silver slurry, or the first sub-fingers 214 are made of burn-through copper slurry.

It should be noted that, in this embodiment of the present application, the plurality of second connection blocks 2122 and the second sub-fingers 215 are stacked. A part that is of the second sub-fingers 215 and that is stacked with the second connection blocks 2122 may also pass through the passivation layer 14 and be in contact with the doped region 12. The second connection blocks 2122 are used to protect the part that is of the second sub-fingers 215 and that is stacked with the second connection blocks 2122, to reduce a degree of a thermal impact on the second sub-fingers 215 when second electrical connectors 52 are welded to the second sub-fingers 215, so as to avoid a damage to the substrate 11 when the second sub-fingers 215 pass through the doped region 12 and reach the substrate 11, and ensure photoelectric conversion efficiency of the photovoltaic module.

The second sub-fingers 215 in this embodiment of the present application may also be made of burn-through metal slurry and are conductive. The second sub-fingers 215 may burn through the passivation layer 14, and is in direct contact with the doped region 12, to form a metal silicide. The metal silicide may enable the second sub-fingers 215 to be in Ohmic contact with the doped region 12, so as to collect currents generated by the substrate 11. For example, the second sub-fingers 215 are made of burn-through silver slurry, or the second sub-fingers 215 are made of burn-through copper slurry.

In an embodiment, the first connection blocks 2121 in this embodiment of the present application are disposed at the passivation layer 14 and do not pass through the passivation layer 14.

In this embodiment of the present application, the first connection blocks 2121 are disposed at the passivation layer 14 and do not pass through the passivation layer 14, so that the first connection blocks 2121 are used to protect the part that is of the first sub-fingers 214 and that is stacked with the first connection blocks 2121, to reduce the degree of the thermal impact on the first sub-fingers 214 when the first electrical connectors 51 are welded to the first sub-fingers 214, so as to avoid the damage to the substrate 11 when the first sub-fingers 214 pass through the doped region 12 and reach the substrate 11, and ensure the photoelectric conversion efficiency of the photovoltaic module.

It may be understood that the first connection blocks 2121 in this embodiment of the present application may be made of non-burn-through metal slurry.

In an embodiment, as shown in FIG. 6 to FIG. 9, in this embodiment of the present application, along the second direction B, the plurality of first connection blocks 2121 are disposed at intervals, the plurality of second connection blocks 2122 are disposed at intervals, and the second connection blocks 2122 and the first connection blocks 2121 are alternately disposed.

As shown in FIG. 6 to FIG. 9, the first sub-fingers 214 and the second sub-fingers 215 in this embodiment of the present application both extend along the first direction A and are alternately arranged along the second direction B. Along the second direction B, the plurality of first connection blocks 2121 are disposed at intervals, and each of the first connection blocks 2121 is stacked with one of the first sub-fingers 214. In a process of preparing the photovoltaic module, the first electrical connectors 51 extend along the second direction B and cover the plurality of first connection blocks 2121, so that the plurality of first connection blocks 2121 are used to protect the part that is of the first sub-fingers 214 and that is stacked with the first connection blocks 2121, to reduce the degree of the thermal impact on the first sub-fingers 214 when the first electrical connectors 51 are welded to the first sub-fingers 214, so as to avoid the damage to the substrate 11 when the first sub-fingers 214 pass through the doped region 12 and reach the substrate 11, and ensure the photoelectric conversion efficiency of the photovoltaic module.

Along the second direction B, the plurality of second connection blocks 2122 are disposed at intervals, and each of the second connection blocks 2122 is stacked with one of the second sub-fingers 215. In the process of preparing the photovoltaic module, the second electrical connectors 52 extend along the second direction B and cover the plurality of second connection blocks 2122, so that the plurality of second connection blocks 2122 are used to protect the part that is of the second sub-fingers 215 and that is stacked with the second connection blocks 2122, to reduce the degree of the thermal impact on the second sub-fingers 215 when the second electrical connectors 52 are welded to the second sub-fingers 215, so as to avoid the damage to the substrate 11 when the second sub-fingers 215 pass through the doped region 12 and reach the substrate 11, and ensure the photoelectric conversion efficiency of the photovoltaic module.

In the process of preparing the photovoltaic module, the first electrical connectors 51 and the second electrical connectors 52 both extend along the second direction B and are alternately arranged along the first direction A. Therefore, in this embodiment of the present application, the second connection blocks 2122 and the first connection blocks 2121 are alternately disposed in a staggered manner along the second direction B, so that the first connection blocks 2121 and the first electrical connectors 51 are correspondingly disposed, and the second connection blocks 2122 and the second electrical connectors 52 are correspondingly disposed.

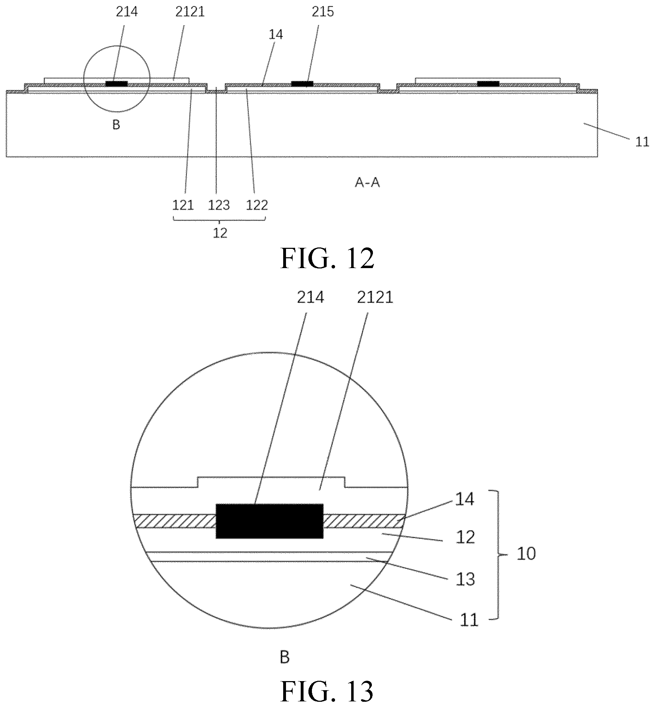

In an embodiment, as shown in FIG. 12 and FIG. 13, along the direction from the second surface to the first surface, the first connection blocks 2121 are stacked on the first sub-fingers 214.

In an implementation, as shown in FIG. 12 and FIG. 13, the first connection blocks 2121 may be stacked on the first sub-fingers 214 along the direction from the second surface to the first surface. Therefore, the first connection blocks 2121 are used to protect the part that is of the first sub-fingers 214 and that is stacked with the first connection blocks 2121. The degree of the thermal impact on the first sub-fingers 214 is reduced, to avoid the damage to the substrate 11 when the first sub-fingers 214 pass through the doped region 12 and reach the substrate 11, and ensure the photoelectric conversion efficiency of the photovoltaic module.

It should be noted that the second connection blocks 2122 in this embodiment of the present application may also be stacked on the second sub-fingers 215, so that the second connection blocks 2122 are used to protect the part that is of the second sub-fingers 215 and that is stacked with the second connection blocks 2122. Therefore, the degree of the thermal impact on the second sub-fingers 215 is reduced, to avoid the damage to the substrate 11 when the second sub-fingers 215 pass through the doped region 12 and reach the substrate 11, and ensure the photoelectric conversion efficiency of the photovoltaic module.

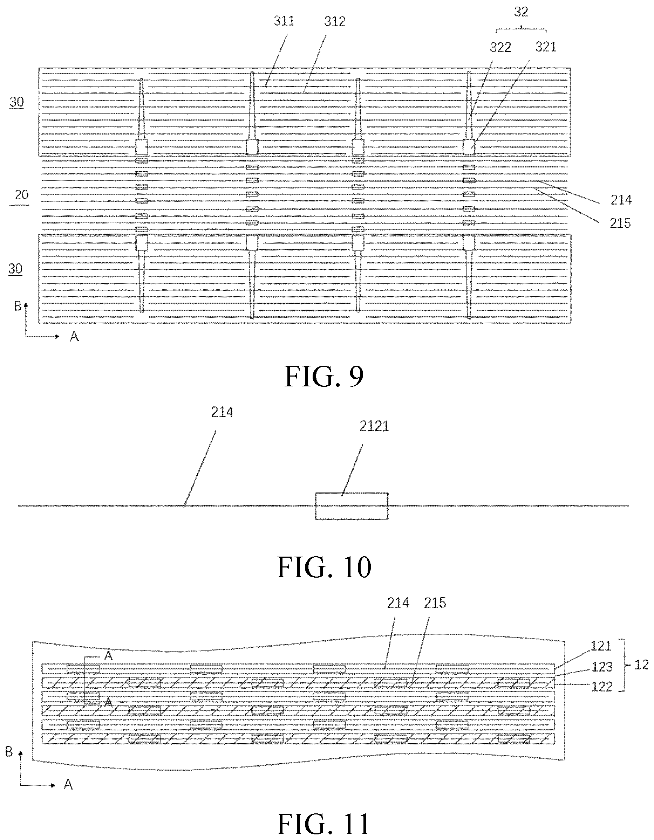

As shown in FIG. 10, it should be noted that, in this embodiment, the part that is of the first sub-fingers 214 and that is stacked with the first connection blocks 2121 is continuous and uninterrupted, that is, P₂=0. The part that is of the second sub-fingers 215 and that is stacked with the second connection blocks 2122 is continuous and uninterrupted.

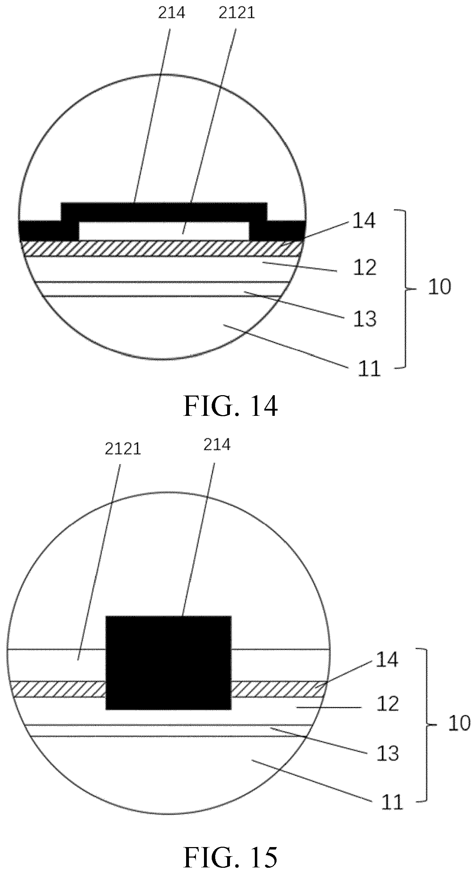

In an embodiment, as shown in FIG. 14 and FIG. 15, the first sub-fingers 214 are stacked on the first connection blocks 2121 along the direction from the second surface to the first surface. The part that is of the first sub-fingers 214 and that is stacked with the first connection blocks 2121 passes through the first connection blocks 2121 and the passivation layer 14 and is in contact with the doped region 12.

As shown in FIG. 14 and FIG. 15, the first sub-fingers 214 are stacked on the first connection blocks 2121 along the direction from the second surface to the first surface. For example, the first sub-fingers 214 are made of burn-through slurry, and the first connection blocks 2121 are made of non-burn-through slurry.

In the process of preparing the photovoltaic module, the first sub-fingers 214 may burn through the first connection blocks 2121 and the passivation layer 14, and are electrically connected to the doped region 12, to collect the currents generated by the solar cell body 10. Further, in this embodiment of the present application, the first connection blocks 2121 are disposed between the first sub-fingers 214 and the passivation layer 14, so that a depth at which the first sub-fingers 214 are sintered into the doped region 12 is less than a depth at which the first sub-fingers 214 directly located at the passivation layer 14 are sintered into the doped region 12, to avoid the damage to the substrate 11 when the first sub-fingers 214 pass through the doped region 12 and reach the substrate 11, and ensure the photoelectric conversion efficiency of the photovoltaic module.

In an implementation, in this embodiment of the present application, along the direction from the second surface to the first surface, the second sub-fingers 215 may also be stacked on the second connection blocks 2122. The part that is of the second sub-fingers 215 and that is stacked with the second connection blocks 2122 passes through the second connection blocks 2122 and the passivation layer 14 and is in contact with the doped region 12.

In this embodiment of the present application, the second sub-fingers 215 are stacked on the second connection blocks 2122 along the direction from the second surface to the first surface. For example, the second sub-fingers 215 are made of burn-through slurry, and the second connection blocks 2122 are made of non-burn-through slurry.

In the process of preparing the photovoltaic module, the second sub-fingers 215 may burn through the second connection blocks 2122 and the passivation layer 14, and are electrically connected to the doped region 12, to collect the currents generated by the solar cell body 10. Further, in this embodiment of the present application, the second connection blocks 2122 are disposed between the second sub-fingers 215 and the passivation layer 14, so that a depth at which the second sub-fingers 215 are sintered into the doped region 12 is less than a depth at which the second sub-fingers 215 directly located at the passivation layer 14 are sintered into the doped region 12, to avoid the damage to the substrate 11 when the second sub-fingers 215 pass through the doped region 12 and reach the substrate 11, and ensure the photoelectric conversion efficiency of the photovoltaic module.

In an embodiment, the first sub-fingers 214 in this embodiment of the present application all pass through the passivation layer 14 and are at least partially embedded in the doped region 12. A depth at which the part that is of the first sub-fingers 214 and that is stacked with the first connection blocks 2121 is embedded in the doped region 12 is less than a depth at which another part of the first sub-fingers 214 is embedded in the doped region 12.

The first sub-fingers 214 in this embodiment of the present application are made of a burn-through metal material, so that the first sub-fingers 214 can pass through the passivation layer 14 and be at least partially embedded in the doped region 12.

In this embodiment of the present application, the depth at which the part that is of the first sub-fingers 214 and that is stacked with the first connection blocks 2121 is embedded in the doped region 12 is set to be less than the depth at which the another part of the first sub-fingers 214 is embedded in the doped region 12. Therefore, a damage to the substrate 11 when the part that is of the first sub-fingers 214 and that is stacked with the first connection blocks 2121 passes through the doped region 12 and reaches the substrate 11, which affects the photoelectric conversion efficiency of the photovoltaic module, is avoided. In other words, through the foregoing setting, the photoelectric conversion efficiency of the photovoltaic module can be ensured.

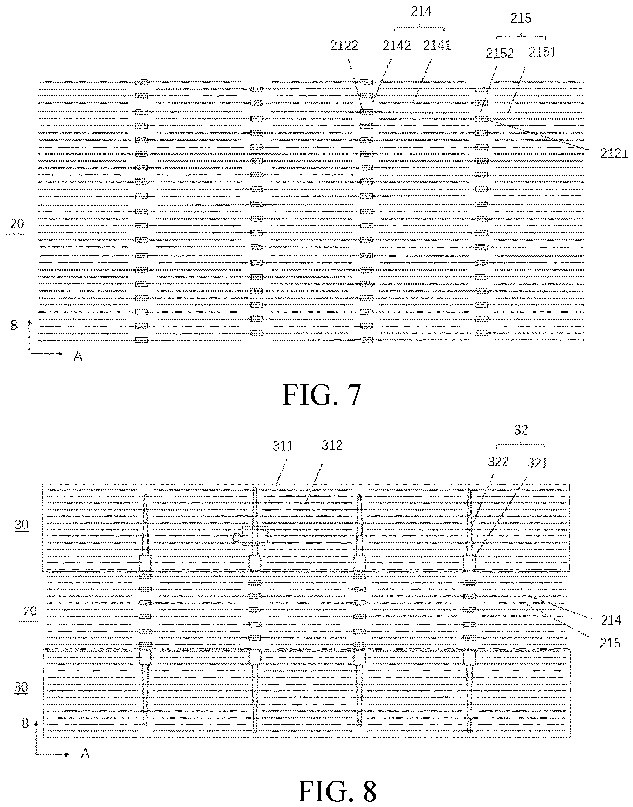

In an embodiment, as shown in FIG. 7 and FIG. 8, the first sub-fingers 214 in this embodiment of the present application include a plurality of first finger segments 2141 disposed at intervals along the first direction A. A first disconnected portion 2142 is disposed between two adjacent first finger segments 2141, and each first disconnected portion 2142 is disposed opposite to one of the second connection blocks 2122 along the second direction B. The second sub-fingers 215 include a plurality of second finger segments 2151 disposed at intervals along the first direction A. A second disconnected portion 2152 is disposed between two adjacent second finger segments 2151, and each second disconnected portion 2152 is disposed opposite to one of the first connection blocks 2121 along the second direction B.

In an implementation, as shown in FIG. 7 and FIG. 8, the first sub-fingers 214 in this embodiment of the present application include the plurality of first finger segments 2141 disposed at intervals along the first direction A. The first disconnected portion 2142 is disposed between two adjacent first finger segments 2141. The second connection segment 212 is not disposed at a position of the first disconnected portion 2142. This is different from the embodiment in FIG. 4. In addition, each first disconnected portion 2142 is disposed opposite to one of the second connection blocks 2122 along the second direction B. In the process of preparing the photovoltaic module, the second electrical connectors 52 need to be engaged to the second connection blocks 2122, and the first disconnected portions 2142 and the second connection blocks 2122 are correspondingly disposed along the second direction B, to avoid a case in which a short circuit occurs in the photovoltaic module because the second electrical connectors 52 are connected to the first sub-fingers 214.

As shown in FIG. 7 and FIG. 8, the second sub-fingers 215 in this embodiment of the present application include the plurality of second finger segments 2151 disposed at intervals along the first direction A. The second disconnected portion 2152 is disposed between two adjacent second finger segments 2151. The second connection segment 212 is not disposed at a position of the second disconnected portion 2152. This is different from the embodiment in FIG. 4. In addition, each second disconnected portion 2152 is disposed opposite to one of the first connection blocks 2121 along the second direction B. In the process of preparing the photovoltaic module, the first electrical connectors 51 need to be engaged to the first connection blocks 2121, and the second disconnected portions 2152 and the first connection blocks 2121 are correspondingly disposed along the second direction B, to avoid a case in which a short circuit occurs in the photovoltaic module because the first electrical connectors 51 are connected to the second sub-fingers 215.

In an embodiment, along the first direction A, a length of the first connection blocks 2121 and/or the second connection blocks 2122 is greater than or equal to 0.3 mm and less than or equal to 0.9 mm, in an embodiment, greater than or equal to 0.3 mm and less than or equal to 0.9 mm. The second connection segments 212 include the first connection blocks 2121 and the second connection blocks 2122. For shapes of the first connection blocks 2121 and the second connection blocks 2122, refer to the second connection segments 212.

In this embodiment of the present application, along the first direction A, the length of the first connection blocks 2121 is set to be greater than or equal to 0.3 mm and less than or equal to 1.5 mm. Therefore, along the first direction A, the length of the first connection blocks 2121 may be greater than a width of the first electrical connectors 51, to avoid an excessively large thermal impact of the first electrical connectors 51 on the first sub-fingers 214, which affects the photoelectric conversion efficiency of the photovoltaic module.

Along the first direction A, the width of the first electrical connectors 51 is usually greater than or equal to 0.15 mm and less than or equal to 0.6 mm. For example, along the first direction A, the width of the first electrical connectors 51 is 0.15 mm, 0.25 mm, 0.3 mm, 0.4 mm, 0.5 mm, or 0.6 mm. Along the first direction A, the length of the first connection blocks 2121 is 0.3 mm, 0.4 mm, 0.5 mm, 0.6 mm, 0.7 mm, 0.8 mm, 0.9 mm, 1.0 mm, 1.1 mm, 1.2 mm, 1.3 mm, 1.4 mm, 1.5 mm, or the like.

In this embodiment of the present application, along the first direction A, the length of the second connection blocks 2122 is set to be greater than or equal to 0.3 mm and less than or equal to 1.5 mm, in an embodiment, greater than or equal to 0.3 mm and less than or equal to 0.9 mm. Therefore, along the first direction A, the length of the second connection blocks 2122 may be greater than a width of the second electrical connectors 52, to avoid an excessively large thermal impact of the second electrical connectors 52 on the second sub-fingers 215, which affects the photoelectric conversion efficiency of the photovoltaic module.

Along the first direction A, the width of the second electrical connectors 52 is usually greater than or equal to 0.15 mm and less than or equal to 0.6 mm. For example, along the first direction A, the width of the second electrical connectors 52 is 0.15 mm, 0.25 mm, 0.3 mm, 0.4 mm, 0.5 mm, or 0.6 mm. Along the first direction A, the length of the second connection blocks 2122 is 0.3 mm, 0.4 mm, 0.5 mm, 0.6 mm, 0.7 mm, 0.8 mm, 0.9 mm, 1.0 mm, 1.1 mm, 1.2 mm, 1.3 mm, 1.4 mm, 1.5 mm, or the like.

In an embodiment, as shown in FIG. 5 to FIG. 9, a width of the first connection blocks 2121 is greater than a width of the first sub-fingers 214, and a width of the second connection blocks 2122 is greater than a width of the second sub-fingers 215.

As shown in FIG. 5 to FIG. 9, in this embodiment of the present application, along the second direction B, the width of the first connection blocks 2121 is set to be greater than the width of the first sub-fingers 214, and a projection of the part that is of the first sub-fingers 214 and that is stacked with the first connection blocks 2121 in a plane on which the first connection blocks 2121 are located falls within the first connection blocks 2121. The first connection blocks 2121 are used to protect the first sub-fingers 214, so that the degree of the thermal impact on the first sub-fingers 214 is reduced, to avoid the damage to the substrate 11 when the first sub-fingers 214 pass through the doped region 12 and reach the substrate 11, and ensure the photoelectric conversion efficiency of the photovoltaic module.

In this embodiment of the present application, along the second direction B, the width of the second connection blocks 2122 is set to be greater than the width of the second sub-fingers 215, and a projection of the part that is of the second sub-fingers 215 and that is stacked with the second connection blocks 2122 in a plane on which the second connection blocks 2122 are located falls within the second connection blocks 2122. The second connection blocks 2122 are used to protect the second sub-fingers 215, so that the degree of the thermal impact on the second sub-fingers 215 is reduced, to avoid the damage to the substrate 11 when the second sub-fingers 215 pass through the doped region 12 and reach the substrate 11, and ensure the photoelectric conversion efficiency of the photovoltaic module.

In an embodiment, along the second direction B, the width of the first sub-fingers 214 and/or the second sub-fingers 215 is greater than or equal to 10 µm and less than or equal to 40 µm, and the width of the first connection blocks 2121 and/or the second connection blocks 2122 is greater than or equal to 80 µm and less than or equal to 200 µm.

In this embodiment of the present application, along the second direction B, the width of the first sub-fingers 214 is greater than or equal to 10 µm and less than or equal to 40 µm, and the width of the first connection blocks 2121 is greater than or equal to 80 µm and less than or equal to 200 µm. For example, along the second direction B, the width of the first sub-fingers 214 is 10 µm, 15 µm, 20 µm, 25 µm, 30 µm, 35 µm, or 40 µm. Along the second direction B, the width of the first connection blocks 2121 is 80 µm, 100 µm, 120 µm, 140 µm, 160 µm, 180 µm, or the like.

In this embodiment of the present application, along the second direction B, the width of the second sub-fingers 215 is greater than or equal to 10 µm and less than or equal to 40 µm, and the width of the second connection blocks 2122 is greater than or equal to 80 µm and less than or equal to 200 µm. For example, along the second direction B, the width of the second sub-fingers 215 is 10 µm, 15 µm, 20 µm, 25 µm, 30 µm, 35 µm, or 40 µm. Along the second direction B, the width of the second connection blocks 2122 is 80 µm, 110 µm, 130 µm, 150 µm, 170 µm, 180 µm, or the like.

In an embodiment, the second connection segments 212 are one of a silver layer, a copper layer, a silver-alloy layer, and a copper-alloy layer.

The second connection segments 212 in this embodiment of the present application are all conductive, and are made of non-burn-through metal slurry. For example, the second connection segments 212 may be made of non-burn-through silver slurry, non-burn-through copper slurry, non-burn-through silver-alloy slurry, or non-burn-through copper-alloy slurry.

Certainly, the foregoing are merely examples of a specific material of the second connection segments 212, and are not intended to limit the present application. During actual application, a skilled person may alternatively select other non-burn-through metal slurry for production based on a requirement.

In an embodiment, as shown in FIG. 11, the doped region 12 in this embodiment of the present application includes a first doped region 121 and a second doped region 122 that extend along the first direction A and are alternately arranged along the second direction B, and an isolation region 123 is provided between the first doped region 121 and the second doped region 122 that are adjacent along the second direction B. Each of the first sub-fingers 214 and one first doped region 121 are correspondingly disposed. The first sub-fingers 214 pass through the passivation layer 14 and are in contact with the first doped region 121. Each of the second sub-fingers 215 and one second doped region 122 are correspondingly disposed. The second sub-fingers 215 pass through the passivation layer 14 and are in contact with the second doped region 122.

As shown in FIG. 11, the doped region 12 in this embodiment of the present application includes the first doped region 121 and the second doped region 122 that extend along the first direction A and are alternately arranged along the second direction B, and the isolation region 123 is provided between the first doped region 121 and the second doped region 122 that are adjacent. The first doped region 121 is connected to a region of the substrate 11, and the second doped region 122 is connected to another region of the substrate 11, to collect, through the first doped region 121 and the second doped region 122, the currents generated by the substrate 11. It may be understood that the first doped region 121 and the second doped region 122 are electrodes of the substrate 11, and the first doped region 121 and the second doped region 122 have opposite polarities.

Further, the isolation region 123 is disposed between the first doped region 121 and the second doped region 122 that are adjacent. The first doped region 121 and the second doped region 122 may be separated by using the isolation region 123, to avoid a short-circuit phenomenon occurring in the photovoltaic module.

It should be noted that the first doped region 121 and the second doped region 122 jointly form the doped region 12. The first doped region 121 and the second doped region 12 may be doped regions generated through in-situ doping on the substrate 11, or may be an additional layer formed on the substrate 11 in a manner such as deposition. In addition, alternatively, one of the first doped region 121 and the second doped region 12 may be a doped region generated through in-situ doping on the substrate 11, and the other may be an additional layer formed on the substrate 11 in a manner such as deposition. When the first doped region 121 and/or the second doped region 122 is the additional layer, the oxide layer 13 is provided between the first doped region 121 and/or the second doped region 122 and the substrate 11.

As shown in FIG. 11, in this embodiment of the present application, each of the first sub-fingers 214 and one first doped region 121 are correspondingly disposed. The first sub-fingers 214 may pass through the passivation layer 14 and be in contact with the first doped region 121, to collect currents in the first doped region 121. Each of the second sub-fingers 215 and one second doped region 122 are correspondingly disposed. The second sub-fingers 215 may pass through the passivation layer 14 and be in contact with the second doped region 122, to collect currents in the second doped region 122.

In an embodiment, as shown in FIG. 15, there are a plurality of metal particles 213 between the part that is of the first sub-fingers 214 and that is stacked with the first connection blocks 2121 and the doped region 12. Along a thickness direction of the solar cell, one end of the metal particles 213 is embedded in the first sub-fingers 214, and the other end is embedded in the doped region 12. In other words, one end of the metal particles 213 is embedded in or connected to the first sub-fingers 214, and the other end is embedded in the first doped region 121.

As shown in FIG. 15, in the process of preparing the photovoltaic module, there are the plurality of metal particles 213 between the part that is of the first sub-fingers 214 and that is stacked with the first connection blocks 2121 and the first doped region 121. One end of the metal particles 213 is embedded in or connected to the first sub-fingers 214, and the other end is embedded in the first doped region 121. However, the metal particles 213 do not enter the substrate 11. Therefore, the metal particles 213 do not damage the substrate 11, and do not affect the photoelectric conversion efficiency of the photovoltaic module.

It should be noted that a material of the metal particles 213 in this embodiment of the present application is the same as the material of the first sub-fingers 214. It may be understood that, after the material of the first sub-fingers 214 is agglomerated, the material of the first sub-fingers 214 is embedded in the first doped region 121, to form the metal particles 213. For example, the metal particles 213 may be metal crystals. The metal particles 213 may further include a silicon material of the first doped region 121, and are formed as metal silicides. In addition, the metal particles in this embodiment of the present application may be connected to the first sub-fingers 214, or may be separated from the first sub-fingers 214.

In an implementation, there are also a plurality of metal particles between the part that is of the second sub-fingers 215 and that is stacked with the second connection blocks 2122 and the doped region 12. One end of the metal particles is embedded in or connected to the second sub-fingers 215, and the other end is embedded in the second doped region 122.

In this embodiment of the present application, in the process of preparing the photovoltaic module, there are also the metal particles between the part that is of the second sub-fingers 215 and that is stacked with the second connection blocks 2122 and the second doped region 122. One end of the metal particles is embedded in the second sub-fingers 215, and the other end is embedded in the second doped region 122. However, the metal particles do not enter the substrate 11. Therefore, the metal particles do not damage the substrate 11, and do not affect the photoelectric conversion efficiency of the photovoltaic module.

It should be noted that a metal material of the metal particles in this embodiment of the present application is the same as the material of the second sub-fingers 215. It may be understood that the material of the second sub-fingers 215 is embedded in the second doped region 122, to form the metal particles. For example, the metal particles may be metal crystals. The metal particles may further include a silicon material of the second doped region 122, and are formed as metal silicides. In addition, the metal particles in this embodiment of the present application may be connected to the second sub-fingers 215, or may be separated from the second sub-fingers 215.

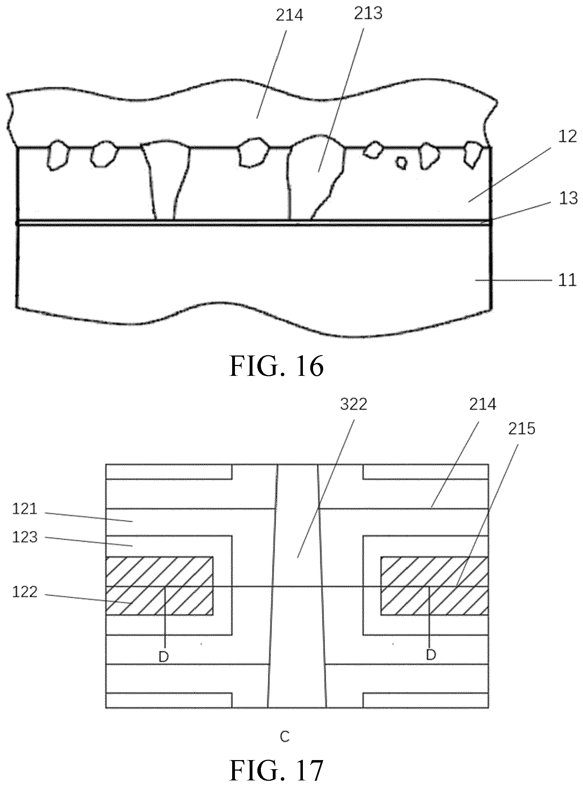

In an embodiment, as shown in FIG. 16, along the thickness direction of the solar cell, the metal particles 213 do not penetrate through the doped region 12, and/or the metal particles 213 are spaced apart from the substrate 11 by at least the oxide layer 13. In this case, when the first doped region 121 is a layer additionally formed on the substrate 11, the first doped region 121 may be, for example, a polysilicon layer.

As shown in FIG. 16, the metal particles 213 do not penetrate through the doped region 12 along the thickness direction of the solar cell, to prevent the metal particles 213 from passing through the doped region 12 and reaching the substrate 11, causing a damage to the substrate 11, and affecting the photoelectric conversion efficiency of the photovoltaic module.

Alternatively, along the thickness direction of the solar cell, the metal particles 213 are spaced apart from the substrate 11 by the oxide layer 13. A thickness of the oxide layer 13 is greater than or equal to 1 nm and less than or equal to 3 nm. For example, the thickness of the oxide layer 13 is 1 nm, 1.5 nm, 2 nm, 2.5 nm, or 3 nm.

As shown in FIG. 16, in this embodiment of the present application, one end of the metal particles 213 is embedded in the first sub-fingers 214, the other end is embedded in the first doped region 121, and the other end of the metal particles 213 is spaced apart from the substrate 11 by the oxide layer 13. In other words, the other end of the metal particles 213 is spaced apart from the substrate 11 by the oxide layer 13. The metal particles 213 do not damage the substrate 11, so that the metal particles 213 can be prevented from affecting the photoelectric conversion efficiency of the photovoltaic module.

In an embodiment, a thickness of the first doped region 121 and/or the second doped region 122 is greater than or equal to 60 nm and less than or equal to 150 nm. In an embodiment, the first doped region 121 and/or the second doped region 122 may be a doped polysilicon layer.

In an embodiment, the thickness of the first doped region 121 is greater than or equal to 60 nm and less than or equal to 150 nm. For example, the thickness of the first doped region 121 is 60 nm, 80 nm, 100 nm, 120 nm, 140 nm, or 150 nm.

In an embodiment, the thickness of the second doped region 122 is greater than or equal to 60 nm and less than or equal to 150 nm. For example, the thickness of the second doped region 122 is 60 nm, 80 nm, 100 nm, 120 nm, 140 nm, or 150 nm.

In an embodiment, as shown in FIG. 8, FIG. 9, and FIG. 17, the solar cell disclosed in this embodiment of the present application further includes the second pattern region 30. The second pattern region 30 is disposed on the first surface, and the second pattern region 30 is disposed adjacent to the first pattern region 20 along the second direction B. In addition, the second pattern region 30 is located at a position closer to an edge of the first surface. The second pattern region 30 includes third sub-fingers 311 and fourth sub-fingers 312 that extend along the first direction A and are alternately arranged along the second direction B. The second pattern region 30 further includes the collecting segments 32, and the collecting segments 32 extend along the second direction B. The collecting segments 32 are connected to the third sub-fingers 311 or the fourth sub-fingers 312. The collecting segments 32 are disposed at the passivation layer, and are not in direct contact with the doped region 12.

As shown in FIG. 8, FIG. 9, and FIG. 17, the second pattern region 30 in this embodiment of the present application is also disposed on the first surface of the solar cell body 10, and the second pattern region 30 is disposed adjacent to the first pattern region 20 along the second direction B. For example, along the second direction B, in comparison with the first pattern region 20, the second pattern region 30 is located in a region closer to an edge of the solar cell body 10.

The second pattern region 30 in this embodiment of the present application includes the third sub-fingers 311 and the fourth sub-fingers 312 that extend along the first direction A and are alternately arranged along the second direction B. The third sub-fingers 311 and the fourth sub-fingers 312 may pass through the passivation layer 14 and contact the doped region 12, to collect the currents generated by the solar cell body 10. The third sub-fingers 311 and the fourth sub-fingers 312 have opposite polarities.

As shown in FIG. 8, FIG. 9, and FIG. 17, the second pattern region 30 further includes the collecting segments 32, and the collecting segments 32 extend along the second direction B. In addition, the collecting segments 32 are disposed at the passivation layer 14, and the collecting segments 32 are not in direct contact with the doped region 12. The collecting segments 32 are not in direct contact with the doped region 12 because the collecting segments 32 have a large width and a large area, and a protective layer in the first pattern region 20 cannot be disposed in a large area. Therefore, the collecting segments 32 do not need to burn through the passivation layer 14.

The collecting segments 32 may be connected to the third sub-fingers 311, to collect currents collected by the third sub-fingers 311. In addition, gaps exist between the collecting segments 32 and the fourth sub-fingers 312, to avoid a short-circuit phenomenon occurring on the solar cell. In other words, the fourth sub-fingers 312 are in an open state at positions of the collecting segments 32.

There are a plurality of collecting segments 32 in this embodiment of the present application. The plurality of collecting segments 32 all extend along the second direction B and are arranged at intervals along the first direction A. When one of the collecting segments 32 is connected to the third sub-finger 311, a gap exists between the collecting segment 32 and the fourth sub-finger 312. Another collecting segment 32 adjacent to the collecting segment 32 may be connected to the fourth sub-finger 312, and a gap exists between the another collecting segment 32 and the third sub-finger 311. In this way, currents collected by the third sub-fingers 311 and the fourth sub-fingers 312 are collected by using the plurality of collecting segments 32.

The collecting segments 32 in this embodiment of the present application do not bum through the passivation layer 14, so that the collecting segments 32 are used to protect the third sub-fingers 311 or the fourth sub-fingers 312, to reduce a degree of a thermal impact on the third sub-fingers 311 and the fourth sub-fingers 312 when the electrical connectors 50 are welded to the third sub-fingers 311 or the fourth sub-fingers 312, so as to avoid a damage to the substrate 11 when the third sub-fingers 311 and the fourth sub-fingers 312 pass through the doped region 12 and reach the substrate 11, and ensure the photoelectric conversion efficiency of the photovoltaic module.

In an embodiment, as shown in FIG. 8, FIG. 9, and FIG. 17, the collecting segments 32 include the collecting points 321 and the end lines 322 connected to the collecting points 321. The end lines 322 are connected to the side that is of the collecting points 321 and that is away from the first pattern region 20. The third sub-fingers 311 are connected to the collecting points 321 and the end lines 322. Gaps exist between the fourth sub-fingers 312 and the collecting points 321 and the end lines 322. The collecting points 321 and the end lines 322 are all disposed at the passivation layer 14, and are not in direct contact with the doped region 12.

As shown in FIG. 8, FIG. 9, and FIG. 17, the collecting segments 32 in this embodiment of the present application include the collecting points 321 and the end lines 322 connected to the collecting points 321. The collecting points 321 and the end lines 322 are arranged along the second direction B. Along the second direction B, the collecting points 321 are located on a side close to the first pattern region 20 of the second pattern region 30, and the end lines 322 are located on a side away from the first pattern region 20 of the second pattern region 30.

The third sub-fingers 311 and the fourth sub-fingers 312 in this embodiment of the present application both extend along the first direction A and are alternately arranged along the second direction B. The third sub-fingers 311 and the fourth sub-fingers 312 have different polarities. It may be understood that, when the third sub-fingers 311 are positive electrode grid lines, the fourth sub-fingers 312 are negative electrode grid lines. When the third sub-fingers 311 are negative electrode grid lines, the fourth sub-fingers 312 are positive electrode grid lines.

As shown in FIG. 8, FIG. 9, and FIG. 17, the third sub-fingers 311 are connected to the collecting points 321 or the end lines 322, to collect, by using the collecting points 321 and/or the end lines 322, the currents collected by the third sub-fingers 311. However, the gaps exist between the fourth sub-fingers 312 and the collecting points 321 and the end lines 322, to avoid a short-circuit phenomenon occurring on the solar cell.

It should be noted that the end lines 322 and the collecting points 321 in this embodiment of the present application are all disposed at the passivation layer 14, and are not in direct contact with the doped region 12. In other words, neither the end lines 322 nor the collecting points 321 burn through the passivation layer 14. Therefore, the end lines 322 and the collecting points 321 may be used to protect the third sub-fingers 311, so that a degree of the thermal impact on the third sub-fingers 311 when the electrical connectors 50 are welded to the third sub-fingers 311 is reduced, to avoid the damage to the substrate 11 when the third sub-fingers 311 pass through the doped region 12 and reach the substrate 11, and ensure the photoelectric conversion efficiency of the photovoltaic module.

As shown in FIG. 19 to FIG. 22, an embodiment of the present application further discloses a photovoltaic module. The photovoltaic module includes a solar cell, where the solar cell includes a solar cell body 10, and the solar cell body 10 includes a substrate, a doped region formed on the substrate, and a passivation layer covering the doped region; a first pattern region 20, where the first pattern region 20 is disposed on a first surface of the solar cell body 10, the first pattern region 20 includes a plurality of first fingers 21 extending along a first direction A and arranged at intervals along a second direction B, each of the first fingers 21 includes a plurality of first connection segments 211 disposed at intervals along the first direction A and second connection segments 212 connected between two adjacent first connection segments 211, and the second direction B intersects with the first direction A, where a plurality of second connection segments 212 are arranged at intervals along the second direction B, and at least one of the first connection segments 211 is disposed between two adjacent second connection segments 212, where the first connection segments 211 burn through the passivation layer and are electrically connected to the doped region, and the second connection segments 212 do not burn through the passivation layer; and electrical connectors 50, where the electrical connectors 50 extend along the second direction B, the electrical connectors 50 are electrically connected to the second connection segments 212, and the electrical connectors 50 are insulated from the first connection segments 211.

As shown in FIG. 19 to FIG. 22, this embodiment of the present application discloses the photovoltaic module. The photovoltaic module includes the solar cell. The solar cell is a core component of the photovoltaic module, and can convert solar energy into electrical energy.

It should be noted that the solar cell included in the photovoltaic module disclosed in this embodiment of the present application is a solar cell with no busbar. A structure of the solar cell with no busbar is the same as a structure of the solar cell with no busbar in the foregoing embodiment, and beneficial effects thereof are also the same or similar. Details are not described herein again.

The photovoltaic module disclosed in this embodiment of the present application further includes the electrical connectors 50. The electrical connectors 50 extend along the second direction B, and are electrically connected to the second connection segments 212 of the plurality of first fingers 21, so that currents collected by the second connection segments 212 of the plurality of first fingers 21 can be transmitted to an external circuit via the electrical connectors 50.

For example, the electrical connectors 50 may be soldered to the second connection segments 212 of the plurality of first fingers 21, so that the electrical connectors 50 are electrically connected to the second connection segments 212 of the plurality of first fingers 21. Certainly, the foregoing is merely an example of a specific manner in which the electrical connectors 50 are electrically connected to the second connection segments 212 of the plurality of first fingers 21, and are not intended to limit the present application. During actual application, a skilled person may alternatively set, according to a requirement, the specific manner in which the electrical connectors 50 are electrically connected to the second connection segments 212 of the plurality of first fingers 21.

It should be noted that the electrical connectors 50 in this embodiment of the present application are insulated from the first connection segments 211. Specifically, an insulating layer 40 may be disposed between the electrical connectors 50 and the first connection segments 211, to block the electrical connectors 50 from the first connection segments 211 by using the insulating layer 40, thereby avoiding a short-circuit phenomenon occurring in the photovoltaic module.

In an embodiment, as shown in FIG. 19 to FIG. 22, the electrical connectors 50 in this embodiment of the present application are insulated from the first connection segments 211 via the insulating layer 40. The insulating layer 40 includes a plurality of insulating strips 41 arranged at intervals along the second direction B, and each of the insulating strips 41 is disposed between one of the first connection segments 211 and one of the electrical connectors 50.

As shown in FIG. 19 to FIG. 22, the insulating layer 40 in this embodiment of the present application includes the plurality of insulating strips 41, and the plurality of insulating strips 41 are arranged at intervals along the second direction B. Each of the insulating strips 41 is disposed between one of the first connection segments 211 and a corresponding electrical connector 50, to block the first connection segment 211 from the corresponding electrical connector 50 by using each of the insulating strips 41, thereby avoiding a case in which electrical connection between the first connection segment 211 and the electrical connector 50 causes a short-circuit phenomenon occurring in the photovoltaic module.

In an embodiment, as shown in FIG. 19 to FIG. 22, the photovoltaic module disclosed in this embodiment of the present application further includes a first engaging layer 60. The first engaging layer 60 includes a plurality of first engaging portions 61 arranged at intervals along the second direction B, and each of the first engaging portions 61 is disposed between one of the second connection segments 212 and one of the electrical connectors 50; and/or a height of the first engaging portions 61 is greater than a height of the insulating strips 41 along a thickness direction of the photovoltaic module.

As shown in FIG. 19 to FIG. 22, the photovoltaic module disclosed in this embodiment of the present application further includes the first engaging layer 60. The first engaging layer 60 includes the plurality of first engaging portions 61. Each of the first engaging portions 61 is a strip-shaped structure extending along the first direction A, and the plurality of first engaging portions 61 are arranged at intervals along the second direction B.

In this embodiment of the present application, each of the first engaging portions 61 is disposed between one of the second connection segments 212 and a corresponding electrical connector 50, to improve reliability of the connection between the second connection segment 212 and the corresponding electrical connector 50 by using the first engaging portion 61.

It should be noted that the first engaging layer 60 in this embodiment of the present application is conductive. Metal slurry is printed, in a manner of screen printing, on surfaces that are of the second connection segments 212 and that are away from the solar cell body 10, to form the first engaging layer 60 between the second connection segments 212 and the corresponding electrical connectors 50. For example, the first engaging layer 60 may be a tin layer.

As shown in FIG. 20 and FIG. 22, the height of the first engaging portions 61 is set to be greater than the height of the insulating strips 41 along the thickness direction of the photovoltaic module, to avoid a case in which the insulating strips 41 are excessively high and push up the electrical connectors 50, and reliability of electrical connection between the first engaging portions 61 and the electrical connectors 50 are consequently affected.

In an embodiment, as shown in FIG. 19 to FIG. 22, along the first direction A, a length of the insulating strips 41 is greater than a length of the first engaging portions 61; and/or the length of the insulating strips 41 and the length of the first engaging portions 61 are both greater than a width of the electrical connectors 50.

As shown in FIG. 19 to FIG. 22, in this embodiment of the present application, the length of the insulating strips 41 is set to be greater than the length of the second connection segments 212 along the first direction A. Therefore, when the electrical connectors 50 deviate, the insulating strips 41 can still ensure reliability of insulation between an anisotropic first finger and the electrical connectors 50, to avoid a short-circuit phenomenon occurring in the photovoltaic module.

In this embodiment of the present application, along the first direction A, the length of the insulating strips 41 and the length of the second connection segments 212 are both set to be greater than the width of the electrical connectors 50. First, along the first direction A, the length of the second connection segments 212 is set to be greater than the width of the electrical connectors 50, so that the electrical connectors 50 can be more reliably connected to the second connection segments 212, thereby improving reliability of electrical connection between the electrical connectors 50 and the anisotropic first finger 21.

In an embodiment, along the first direction A, the length of the insulating strips 41 is set to be greater than the length of the second connection segments 212, to improve the reliability of the insulation between the anisotropic first finger 21 and the electrical connectors 50, thereby avoiding a short-circuit phenomenon occurring in the photovoltaic module.

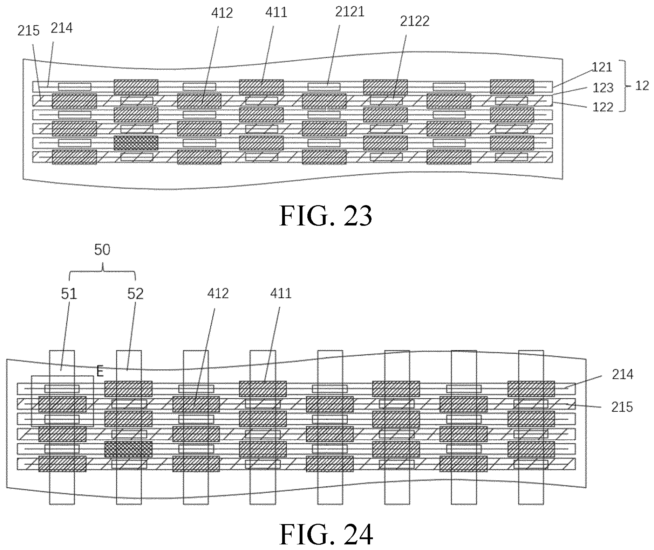

In an embodiment, referring to FIG. 24, first insulating strips 411 cover the first sub-fingers 214, and second insulating strips 412 cover the second sub-fingers 215. The first electrical connectors 51 are sequentially and alternately disposed on the first connection blocks 2121 and the second insulating strips 412 along the second direction B, to implement electrical connection to the first sub-fingers 214 and implement electrical insulation from the second sub-fingers 215. Similarly, the second electrical connectors 215 are sequentially and alternately disposed on the second connection blocks 2122 and the first insulating strips 411 along the second direction B, to implement electrical connection to the second sub-fingers 215 and electrical insulation from the first sub-fingers 214.

In an embodiment, referring to FIG. 21, along the first direction A, a size of a part that projects from the second connection segments 212 at any end of the insulating strips 41 is x (that is, a difference between a length of the insulating strips 41 on a single side and a length of the second connection segments 212 on a single side when two parts are obtained through segmentation along a center line of the second connection segments 212 (where the center line extends along the second direction B)), satisfying 0.8d-0.1 mm<x<1.2d+0.1 mm, where d represents a width of the electrical connectors 50 along the first direction A. Setting in this way is beneficial to compensate for an offset of the electrical connectors relative to the engaging portions that is caused by device precision and the like, to effectively prevent a short circuit caused when the electrical connectors are in contact with anisotropic engaging portions and grid lines.

In an embodiment, the size of the part that projects from the second connection segments 212 at any end of the insulating strips 41 satisfies d-0.1 mm≤x≤d+0.1 mm, and for an electrical connector whose d ranges from 0.15 mm to 0.3 mm, for example, 0.38 mm<x<0.82 mm. In an embodiment, the length of the insulating strips 41 along the first direction A ranges from 1 mm to 3 mm.

Referring to FIG. 19, the width of the first insulating strips 411 along the second direction B is y, satisfying b+65 µm≤y≤D-55 µm, where b represents the width of the first sub-fingers 214 along the second direction B, and D represents a distance between engaging portions (5) on two sides of the first insulating strips 411 along the second direction B. In an embodiment, the widths of the second insulating strips 412 and the second sub-fingers 215 also satisfy the relationship. The size of the width of the insulating strips 41 along the second direction B is configured to satisfy 0.2 mm≤y≤0.6 mm.

In this implementation, the foregoing size design is performed on the width of the insulating strips 41, so that an impact that is limited by precision of a used printing device (such as a wire mesh) and that is on the first insulating strips 411 or the second insulating strips 412 relative to the correspondingly covered first sub-fingers 214 or second sub-fingers 215 along the second direction B (an up-down direction shown in FIG. 19) in a process of actually printing the first insulating strips 411 or the second insulating strips 412. Further, based on the foregoing size design, the width of the insulating strips 41 may further be supplemented with performance (for example, a tension of insulation adhesive in a liquid state) and a manufacturing process (for example, being released from the wire mesh) of a material (for example, the insulation adhesive) for printing the insulating layer 40, so that the foregoing width configuration of the insulating strips 41 may further be supplemented with a boundary thickness margin of an edge of the insulating strips 41 close to the second direction B, to avoid a problem that the first finger 21 cannot be effectively covered due to an excessively small thickness of the insulating layer 40 at an edge position of the insulating strips 41.

In an embodiment, a thickness of the insulating strips 41 along a third direction is z, satisfying z≥h+18 µm, where h represents a thickness of the first finger 21 (in particular, the second connection segments 212) corresponding to a single insulating strip 41. Setting in this way can prevent a short-circuit problem caused when the insulating strip 41 is penetrated. z satisfies 20 µm≤z≤60 µm. In an embodiment, as shown in FIG. 22, a height of middle regions of the insulating strips 41 is greater than a height of two-side regions of the insulating strips 41 along the second direction B.

As shown in FIG. 22, in this embodiment of the present application, the height of the middle regions of the insulating strips 41 is set to be greater than the height of the two-side regions of the insulating strips 41 along the second direction B. Through the foregoing setting, an excessively large contact area between the electrical connectors 50 and the insulating strips 41, which affects the reliability of the electrical connection between the electrical connectors 50 and the second connection segments 212, can be avoided.

Further, through the foregoing setting, when insulation is ensured, an amount of insulating materials in the insulating strips 41 can also be reduced, thereby reducing costs of the photovoltaic module.

In an embodiment, as shown in FIG. 22, the photovoltaic module disclosed in this embodiment of the present application further includes a second engaging layer 70. The second engaging layer 70 includes a plurality of second engaging portions 71 extending along the first direction A and arranged at intervals along the second direction B. Each of the second engaging portions 71 is disposed between one of the insulating strips 41 and one of the electrical connectors 50; and/or each of the second engaging portions 71 is disposed between two first engaging portions 61 adjacently disposed along the second direction B.

As shown in FIG. 22, the photovoltaic module disclosed in this embodiment of the present application further includes the second engaging layer 70. The second engaging layer 70 includes the plurality of second engaging portions 71. The plurality of second engaging portions 71 are strip-shaped structures extending along the first direction A, and the plurality of second engaging portions 71 are arranged at intervals along the second direction B.

In this embodiment of the present application, each of the second engaging portions 71 is disposed between one of the insulating strips 41 and one of the electrical connectors 50, and each of the second engaging portions 71 is disposed between the two first engaging portions 61 adjacently disposed along the second direction B.

In an embodiment, along the second direction B, each of the second engaging portions 71 may be connected to two adjacent first engaging portions 61, to further improve the reliability of the connection between the electrical connectors 50 and the second connection segments 212, and prevent a protrusion generated by the electrical connectors 50 from affecting an appearance of the photovoltaic module.

It should be noted that the second engaging portions 71 in this embodiment of the present application are mainly combinations of organic matters and solders. A source of the organic matters is mainly organic materials in the first engaging portions 61. A source of the solders is mainly solders carried in the electrical connectors 50 and other extending solders. There are more second engaging portions 71 in gaps between the electrical connectors 50 and the insulating strips 41.

In an embodiment, the solar cell disclosed in this embodiment of the present application further includes: a second pattern region 30. The second pattern region 30 is disposed on the first surface of the solar cell body 10, and is disposed spaced away with the first pattern region 20 along the second direction B. The second pattern region 30 includes collecting segments 32. Overlapping regions exist between end portions of the electrical connectors 50 and projections of the collecting segments 32 on the solar cell body 10.

In this embodiment of the present application, the second pattern region 30 is further provided on the back surface of the solar cell body 10. A structure of the solar cell including the second pattern region 30 in this embodiment of the present application is the same as that of the solar cell including the second pattern region 30 in the foregoing embodiment, and beneficial effects thereof are also the same or similar. Details are not described herein again.

The photovoltaic module disclosed in this embodiment of the present application further includes the electrical connectors 50, and the electrical connectors 50 extend along the second direction B. Overlapping regions exist between the electrical connectors 50 and the projections of the collecting segments 32 on the solar cell body 10. In other words, the electrical connectors 50 extend above the collecting segments 32, and are connected to the collecting segments 32, to transmit currents collected by the collecting segments 32 to an external circuit.

For example, the collecting segments 32 include collecting points 321 and end lines 322 connected to the collecting points 321. The electrical connectors 50 may be electrically connected to the collecting points 321. To be specific, the electrical connectors 50 are disposed above the collecting points 321, and are connected to the collecting points 321. In addition, the electrical connectors 50 extend above the end lines 322, and are electrically connected to the end lines 322. Therefore, currents collected by the collecting points 321 and the end lines 322 can be transmitted to the external circuit via the electrical connectors 50. Therefore, a current collection efficiency is improved, and a photoelectric conversion efficiency of the photovoltaic module is improved.

In an embodiment, a ratio of a length of the overlapping regions to a length of the collecting segments 32 along the second direction B is greater than or equal to 0.1 and less than or equal to 0.5. In this embodiment of the present application, the ratio of the length of the overlapping regions to the length of the collecting segments 32 is set to be greater than or equal to 0.1 and less than or equal to 0.5, to ensure reliability of electrical connection between the electrical connectors 50 and the collecting segments 32. Therefore, reliability of current collection and the photoelectric conversion efficiency of the photovoltaic module are both improved.

For example, the ratio of the length of the overlapping regions to the length of the collecting segments 32 may be set to 0.1, 0.2, 0.3, 0.4, or 0.5.

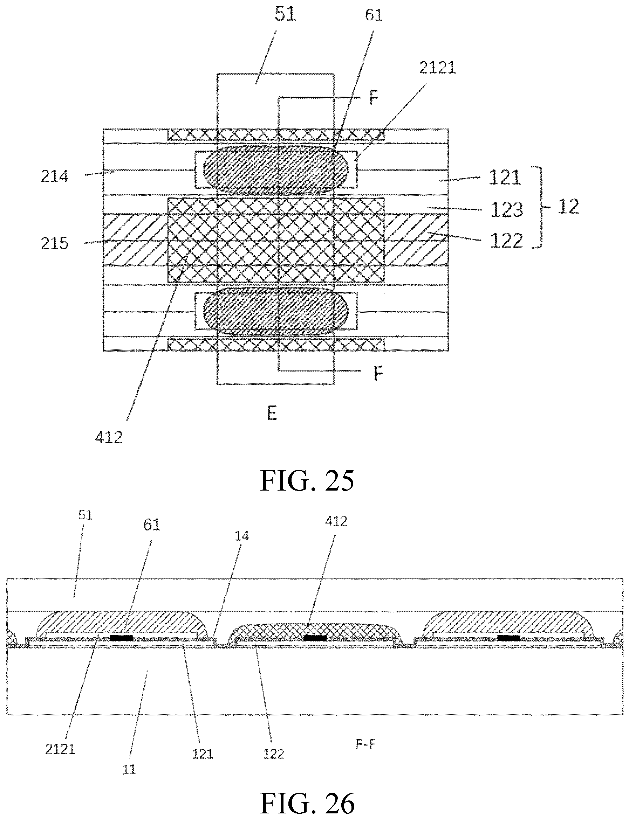

In an embodiment, as shown in FIG. 23 to FIG. 26, the photovoltaic module in some embodiments includes the electrical connectors 50 and the solar cell in the foregoing embodiments. The electrical connectors 50 extend along the second direction B and are engaged to the second connection segments 212.

As shown in FIG. 23 to FIG. 26, the photovoltaic module disclosed in this embodiment of the present application includes the solar cell and the electrical connectors 50 in the foregoing embodiments. The electrical connectors 50 extend along the second direction B and are engaged to the second connection segments 212. Therefore, the second connection segments 212 are used to protect a part that is of the first sub-fingers 214 and that is stacked with the second connection segments 212, and the second connection segments 212 are used to protect a part that is of the second sub-fingers 215 and that is stacked with the second connection segments 212, to reduce a degree of a thermal impact on the first sub-fingers 214 and the second sub-fingers 215 when the electrical connectors 50 are welded to the first sub-fingers 214 and the second sub-fingers 215, so as to avoid a damage to the substrate 11 when the first sub-fingers 214 and the second sub-fingers 215 pass through the doped region 12 and reach the substrate 11, which affects photoelectric conversion efficiency of the photovoltaic module.

It should be noted that the electrical connectors 50 are conductive, and the electrical connectors 50 may transmit currents generated by the solar cell to an external circuit. For example, the electrical connectors 50 may be welding strips, and cross sections of the welding strips may be a structure of a circle, an ellipse, or a rectangle, or a quasi-rectangular structure.

In an embodiment, as shown in FIG. 23 to FIG. 26, the electrical connectors 50 in this embodiment of the present application include the first electrical connectors 51 and the second electrical connectors 52. The first electrical connectors 51 and the second electrical connectors 52 all extend along the second direction B and are alternately arranged along the first direction A. The first electrical connectors 51 are coupled to the first connection blocks 2121, and the second electrical connectors 52 are coupled to the second connection blocks 2122.

As shown in FIG. 23 to FIG. 26, the first electrical connectors 51 and the second electrical connectors 52 in this embodiment of the present application all extend along the second direction B and are alternately arranged along the first direction A. The first electrical connectors 51 are coupled to the first connection blocks 2121, so that the first connection blocks 2121 are used to protect the part that is of the first sub-fingers 214 and that is stacked with the first connection blocks 2121. Therefore, a degree of a thermal impact on the first sub-fingers 214 when the first electrical connectors 51 are welded to the first sub-fingers 214 is reduced, to avoid the damage to the substrate 11 when the first sub-fingers 214 pass through the doped region 12 and reach the substrate 11, which affects the photoelectric conversion efficiency of the photovoltaic module.

Further, the second electrical connectors 52 are coupled to the second connection blocks 2122, so that the second connection blocks 2122 are used to protect the part that is of the second sub-fingers 215 and that is stacked with the second connection blocks 2122. Therefore, a degree of a thermal impact on the second sub-fingers 215 when the second electrical connectors 52 are welded to the second sub-fingers 215 is reduced, to avoid the damage to the substrate 11 when the second sub-fingers 215 pass through the doped region 12 and reach the substrate 11, which affects the photoelectric conversion efficiency of the photovoltaic module.

In an embodiment, as shown in FIG. 23 to FIG. 26, the first insulating strips 411 are disposed at a position at which the first sub-fingers 214 are connected to the second electrical connectors 52, and the second insulating strips 412 are disposed at a position at which the second sub-fingers 215 are connected to the first electrical connectors 51.

As shown in FIG. 23 to FIG. 26, in this embodiment of the present application, the first insulating strips 411 are disposed at the position at which the first sub-fingers 214 are connected to the second electrical connectors 52, to block the first sub-fingers 214 and the second electrical connectors 52 by using the first insulating strips 411, and avoid a short-circuit phenomenon occurring in the photovoltaic module when the first sub-fingers 214 are connected to the second electrical connectors 52.

In this embodiment of the present application, the second insulating strips 412 are disposed at the position at which the second sub-fingers 215 are connected to the first electrical connectors 51, to block the second sub-fingers 215 and the first electrical connectors 51 by using the second insulating strips 412, and avoid a short-circuit phenomenon occurring in the photovoltaic module when the second sub-fingers 215 are connected to the first electrical connectors 51.

In an embodiment, as shown in FIG. 23 to FIG. 26, along the second direction B, the second insulating strip 412 is located between two adjacent first connection blocks 2121, and a width of the second insulating strip 412 is less than or equal to a distance between the two adjacent first connection blocks 2121. Along the second direction B, the first insulating strip 411 is located between two adjacent second connection blocks 2122, and a width of the first insulating strip 411 is less than or equal to a distance between the two adjacent second connection blocks 2122.

As shown in FIG. 23 to FIG. 26, in this embodiment of the present application, along the second direction B, the second insulating strip 412 is located between the two adjacent first connection blocks 2121, and along the second direction B, the width of the second insulating strip 412 is less than or equal to the distance between the two adjacent first connection blocks 2121. Therefore, disposing of the second insulating strip 412 does not affect reliability of connection between the first sub-fingers 214 and the first electrical connectors 51, to ensure the photoelectric conversion efficiency of the photovoltaic module.

In this embodiment of the present application, along the second direction B, the first insulating strip 411 is located between the two adjacent second connection blocks 2122, and along the second direction B, the width of the first insulating strip 411 is less than or equal to the distance between the two adjacent second connection blocks 2122. Therefore, disposing of the first insulating strip 411 does not affect reliability of connection between the second sub-fingers 215 and the second electrical connectors 52, to ensure the photoelectric conversion efficiency of the photovoltaic module.

In an embodiment, as shown in FIG. 23 to FIG. 26, along the first direction A, the length of the first connection blocks 2121 is greater than the width of the first electrical connectors 51, and the length of the second connection blocks 2122 is greater than the width of the second electrical connectors 52.

As shown in FIG. 23 to FIG. 26, in this embodiment of the present application, along the first direction A, the length of the first connection blocks 2121 is set to be greater than the width of the first electrical connectors 51, to avoid an excessively large thermal impact of the first electrical connectors 51 on the first sub-fingers 214 when the first electrical connectors 51 contact the first sub-fingers 214, which affects the photoelectric conversion efficiency of the photovoltaic module.

In this embodiment of the present application, along the first direction A, the length of the second connection blocks 2122 is set to be greater than the width of the second electrical connectors 52, to avoid an excessively large thermal impact of the second electrical connectors 52 on the second sub-fingers 215 when the second electrical connectors 52 contact the second sub-fingers 215, which affects the photoelectric conversion efficiency of the photovoltaic module.

It should be noted that the embodiments in this specification are all described in a progressive manner. Descriptions of each embodiment focus on differences from other embodiments, and reference may be made to each other for the same or similar parts among respective embodiments.

Although optional embodiments of the embodiments of the present application have been described, a person skilled in the art can make other changes and modifications to these embodiments once learning the basic inventive concept. Therefore, the following claims are intended to be explained as including the optional embodiments and all the changes and modifications falling within the scope of the claims.

Finally, it should be further noted that the relational terms herein such as first and second are used only to differentiate an entity from another entity, and do not require or imply any actual relationship or sequence between these entities. In addition, the terms "include" "comprise" and any other variants are intended to cover non-exclusive inclusion, so that an object or a terminal device that includes a series of elements not only includes such elements, but also includes other elements not expressly listed, or further includes elements inherent to the object or the terminal device. If no more limitations are made, an element limited by "include a/an..." does not exclude other same elements existing in an object or a terminal device that includes the element.

The technical solutions provided in the present application are described above in detail. Although the principles and implementations of the present application are described by using specific examples in this specification, a person of ordinary skill in the art may make variations to the specific implementations falling within the scope of the claims.

In conclusion, the content of this specification should not be construed as a limitation to the present application.

## Claims

1. A solar cell, wherein the solar cell comprises:
a solar cell body (10), wherein the solar cell body (10) comprises a substrate (11), a doped region (12) formed on the substrate (11), and a passivation layer (14) covering the doped region (12); and
a first pattern region (20), wherein the first pattern region (20) is disposed at the passivation layer (14), the first pattern region (20) comprises a plurality of first fingers (21) extending along a first direction (A) and arranged at intervals along a second direction (B), each of the first fingers (21) comprises a plurality of first connection segments (211) disposed at intervals along the first direction (A) and second connection segments (212) connected between two adjacent first connection segments (211), and the second direction (B) intersects with the first direction (A), wherein
a plurality of second connection segments (212) are arranged at intervals along the second direction (B), and at least one of the first connection segments (211) is disposed between two adjacent second connection segments (212), wherein the first connection segments (211) burn through the passivation layer (14) and are electrically connected to the doped region (12), and the second connection segments (212) do not burn through the passivation layer (14); and
a width of each of the second connection segments (212) is greater than a width of each of the first connection segments (211) along the second direction (B) **characterized in that**
a second pattern region (30), wherein the second pattern region (30) is disposed at the passivation layer (14), and is disposed adjacent to the first pattern region (20) along the second direction (B), wherein
the second pattern region (30) comprises a plurality of second fingers (31) extending along the first direction (A) and arranged at intervals along the second direction (B), the second pattern region (30) further comprises collecting segments (32), and the collecting segments (32) extend along the second direction (B), wherein
a part of the second fingers (31) are connected to the collecting segments (32).

2. The solar cell according to claim 1, wherein a length of each of the first connection segments (211) is greater than a length of each of the second connection segments (212) along the first direction (A).

3. The solar cell according to claim 1, wherein a polarity of each of the second connection segments (212) is opposite to a polarity of an adjacent first connection segment (211) along the second direction (B).

4. The solar cell according to claim 3, wherein the solar cell further comprises an insulating layer (40), wherein
the insulating layer (40) comprises a plurality of insulating strips (41) extending along the first direction (A) and arranged at intervals along the second direction (B), and each of the insulating strips (41) covers a part that is of one of the first connection segments (211) and that is located between two adjacent second connection segments (212).

5. The solar cell according to claim 4, wherein, along the second direction (B), a distance between a side edge that is of each of the second connection segments (212) and that is close to an adjacent insulating strip (41) and a side edge that is of the adjacent insulating strip (41) and that is close to the second connection segment (212) is d4, and d4≥40 µm is satisfied.

6. The solar cell according to claim 3, wherein each of the first connection segments (211) has a first projection and each of the second connection segments (212) has a second projection in a plane on which the solar cell body (10) is located, and the first projection at least partially falls within the second projection; and
a distance between two adjacent first fingers (21) having a same polarity along the second direction (B) is P1, a distance by which two first connection segments (211) connected to a same second connection segment (212) are separated along the first direction (A) is P2, and P₂≤P₁ is satisfied.

7. The solar cell according to claim 6, wherein a length of the second connection segments (212) along the first direction (A) is P3, and P2<P3 is satisfied; and/or
P2>0 mm, and 0.5 mm≤P1≤1.5 mm.

8. A photovoltaic module, comprising:
a solar cell according to claim 1;
and
electrical connectors (50), wherein the electrical connectors (50) extend along the second direction (B), the electrical connectors (50) are electrically connected to the second connection segments (212), and the electrical connectors (50) are insulated from the first connection segments (211);
and
overlapping regions exist between end portions of the electrical connectors (50) and projections of the collecting segments (32) on the solar cell body (10).

9. The photovoltaic module according to claim 8, wherein the electrical connectors (50) are insulated from the first connection segments (211) via an insulating layer (40); and
the insulating layer (40) comprises a plurality of insulating strips (41) arranged at intervals along the second direction (B), and each of the insulating strips (41) is disposed between one of the first connection segments (211) and one of the electrical connectors (50).

10. The photovoltaic module according to claim 9, wherein the photovoltaic module further comprises a first engaging layer (60), wherein
the first engaging layer (60) comprises a plurality of first engaging portions (61) arranged at intervals along the second direction (B), and each of the first engaging portions (61) is disposed between one of the second connection segments (212) and one of the electrical connectors (50); and/or
a height of the first engaging portions (61) is greater than a height of the insulating strips (41) along a thickness direction of the photovoltaic module.

11. The photovoltaic module according to claim 10, wherein, along the first direction (A), a length of the insulating strips (41) is greater than a length of the first engaging portions (61); and/or
the length of the insulating strips (41) and the length of the first engaging portions (61) are both greater than a width of the electrical connectors (50).

12. The photovoltaic module according to claim 9, wherein a height of middle regions of the insulating strips (41) is greater than a height of two-side regions of the insulating strips (41) along the second direction (B).

13. The photovoltaic module according to claim 8, wherein a ratio of a length of the overlapping regions to a length of the collecting segments (32) along the second direction (B) is greater than or equal to 0.1 and less than or equal to 0.5.

## Patentansprüche

1. Solarzelle, wobei die Solarzelle umfasst:
einen Solarzellenkörper (10), wobei der Solarzellenkörper (10) ein Substrat (11), einen auf dem Substrat (11) ausgebildeten dotierten Bereich (12) und eine den dotierten Bereich (12) bedeckende Passivierungsschicht (14) umfasst; und
einen ersten Musterbereich (20), wobei der erste Musterbereich (20) an der Passivierungsschicht (14) angeordnet ist, der erste Musterbereich (20) eine Vielzahl erster Finger (21) umfasst, die sich entlang einer ersten Richtung (A) erstrecken und in Abständen entlang einer zweiten Richtung (B) angeordnet sind, wobei jeder der ersten Finger (21) eine Vielzahl erster Verbindungssegmente (211), die in Abständen entlang der ersten Richtung (A) angeordnet sind, und zweite Verbindungssegmente (212), die zwischen zwei benachbarten ersten Verbindungssegmenten (211) verbunden sind, umfasst, und wobei sich die zweite Richtung (B) mit der ersten Richtung (A) schneidet, wobei
eine Vielzahl zweiter Verbindungssegmente (212) in Abständen entlang der zweiten Richtung (B) angeordnet ist und wenigstens eines der ersten Verbindungssegmente (211) zwischen zwei benachbarten zweiten Verbindungssegmenten (212) angeordnet ist, wobei die ersten Verbindungssegmente (211) durch die Passivierungsschicht (14) hindurchgebrannt sind und elektrisch mit dem dotierten Bereich (12) verbunden sind und die zweiten Verbindungssegmente (212) nicht durch die Passivierungsschicht (14) hindurchgebrannt sind; und
eine Breite jedes der zweiten Verbindungssegmente (212) entlang der zweiten Richtung (B) größer als eine Breite jedes der ersten Verbindungssegmente (211) ist, **dadurch gekennzeichnet, dass**
ein zweiter Musterbereich (30), wobei der zweite Musterbereich (30) an der Passivierungsschicht (14) angeordnet ist und angrenzend an den ersten Musterbereich (20) entlang der zweiten Richtung (B) angeordnet ist, wobei
der zweite Musterbereich (30) eine Vielzahl zweiter Finger (31) umfasst, die sich entlang der ersten Richtung (A) erstrecken und in Abständen entlang der zweiten Richtung (B) angeordnet sind, der zweite Musterbereich (30) ferner Sammelsegmente (32) umfasst und sich die Sammelsegmente (32) entlang der zweiten Richtung (B) erstrecken, wobei
ein Teil der zweiten Finger (31) mit den Sammelsegmenten (32) verbunden ist.

2. Solarzelle nach Anspruch 1, wobei eine Länge jedes der ersten Verbindungssegmente (211) entlang der ersten Richtung (A) größer als eine Länge jedes der zweiten Verbindungssegmente (212) ist.

3. Solarzelle nach Anspruch 1, wobei eine Polarität jedes der zweiten Verbindungssegmente (212) entlang der zweiten Richtung (B) entgegengesetzt zu einer Polarität eines benachbarten ersten Verbindungssegments (211) ist.

4. Solarzelle nach Anspruch 3, wobei die Solarzelle ferner eine Isolierschicht (40) umfasst, wobei
die Isolierschicht (40) eine Vielzahl von Isolierstreifen (41) umfasst, die sich entlang der ersten Richtung (A) erstrecken und in Abständen entlang der zweiten Richtung (B) angeordnet sind, und jeder der Isolierstreifen (41) einen Teil bedeckt, der zu einem der ersten Verbindungssegmente (211) gehört und zwischen zwei benachbarten zweiten Verbindungssegmenten (212) angeordnet ist.

5. Solarzelle nach Anspruch 4, wobei entlang der zweiten Richtung (B) ein Abstand zwischen einer Seitenkante, die zu jedem der zweiten Verbindungssegmente (212) gehört und nahe einem benachbarten Isolierstreifen (41) liegt, und einer Seitenkante, die zu dem benachbarten Isolierstreifen (41) gehört und nahe dem zweiten Verbindungssegment (212) liegt, d4 ist und d4≥40 µm erfüllt ist.

6. Solarzelle nach Anspruch 3, wobei jedes der ersten Verbindungssegmente (211) eine erste Projektion und jedes der zweiten Verbindungssegmente (212) eine zweite Projektion in einer Ebene aufweist, in der sich der Solarzellenkörper (10) befindet, und die erste Projektion wenigstens teilweise innerhalb der zweiten Projektion liegt; und
ein Abstand zwischen zwei benachbarten ersten Fingern (21), die entlang der zweiten Richtung (B) die gleiche Polarität aufweisen, P1 ist, ein Abstand, um den zwei erste Verbindungssegmente (211), die mit demselben zweiten Verbindungssegment (212) verbunden sind, entlang der ersten Richtung (A) voneinander beabstandet sind, P2 ist, und P2≤P1 erfüllt ist.

7. Solarzelle nach Anspruch 6, wobei eine Länge der zweiten Verbindungssegmente (212) entlang der ersten Richtung (A) P3 ist und P2<P3 erfüllt ist; und/oder
P2>0 mm und 0,5 mm≤P1≤1,5 mm.

8. Photovoltaikmodul, umfassend:
eine Solarzelle nach Anspruch 1; und
elektrische Verbinder (50), wobei sich die elektrischen Verbinder (50) entlang der zweiten Richtung (B) erstrecken, die elektrischen Verbinder (50) elektrisch mit den zweiten Verbindungssegmenten (212) verbunden sind und die elektrischen Verbinder (50) von den ersten Verbindungssegmenten (211) isoliert sind; und
Überlappungsbereiche zwischen Endabschnitten der elektrischen Verbinder (50) und Projektionen der Sammelsegmente (32) auf den Solarzellenkörper (10) vorhanden sind.

9. Photovoltaikmodul nach Anspruch 8, wobei die elektrischen Verbinder (50) über eine Isolierschicht (40) von den ersten Verbindungssegmenten (211) isoliert sind; und
die Isolierschicht (40) eine Vielzahl von Isolierstreifen (41) umfasst, die in Abständen entlang der zweiten Richtung (B) angeordnet sind, und jeder der Isolierstreifen (41) zwischen einem der ersten Verbindungssegmente (211) und einem der elektrischen Verbinder (50) angeordnet ist.

10. Photovoltaikmodul nach Anspruch 9, wobei das Photovoltaikmodul ferner eine erste Eingriffsschicht (60) umfasst, wobei
die erste Eingriffsschicht (60) eine Vielzahl erster Eingriffsabschnitte (61) umfasst, die in Abständen entlang der zweiten Richtung (B) angeordnet sind, und jeder der ersten Eingriffsabschnitte (61) zwischen einem der zweiten Verbindungssegmente (212) und einem der elektrischen Verbinder (50) angeordnet ist; und/oder
eine Höhe der ersten Eingriffsabschnitte (61) entlang einer Dickenrichtung des Photovoltaikmoduls größer als eine Höhe der Isolierstreifen (41) ist.

11. Photovoltaikmodul nach Anspruch 10, wobei entlang der ersten Richtung (A) eine Länge der Isolierstreifen (41) größer als eine Länge der ersten Eingriffsabschnitte (61) ist; und/oder
die Länge der Isolierstreifen (41) und die Länge der ersten Eingriffsabschnitte (61) beide größer als eine Breite der elektrischen Verbinder (50) sind.

12. Photovoltaikmodul nach Anspruch 9, wobei eine Höhe mittlerer Bereiche der Isolierstreifen (41) entlang der zweiten Richtung (B) größer als eine Höhe beidseitiger Bereiche der Isolierstreifen (41) ist.

13. Photovoltaikmodul nach Anspruch 8, wobei ein Verhältnis einer Länge der Überlappungsbereiche zu einer Länge der Sammelsegmente (32) entlang der zweiten Richtung (B) größer als oder gleich 0,1 und kleiner als oder gleich 0,5 ist.

## Revendications

1. Cellule solaire, dans laquelle la cellule solaire comprend :
un corps de cellule solaire (10), dans lequel le corps de cellule solaire (10) comprend un substrat (11), une région dopée (12) formée sur le substrat (11) et une couche de passivation (14) recouvrant la région dopée (12) ; et
une première région de motif (20), dans laquelle la première région de motif (20) est disposée au niveau de la couche de passivation (14), la première région de motif (20) comprend une pluralité de premiers doigts (21) s'étendant le long d'une première direction (A) et disposés à intervalles le long d'une deuxième direction (B), chacun des premiers doigts (21) comprend une pluralité de premiers segments de connexion (211) disposés à intervalles le long de la première direction (A) et des deuxièmes segments de connexion (212) reliés entre deux premiers segments de connexion (211) adjacents, et la deuxième direction (B) croise la première direction (A), dans laquelle
une pluralité de deuxièmes segments de connexion (212) sont disposés à intervalles le long de la deuxième direction (B), et au moins l'un des premiers segments de connexion (211) est disposé entre deux deuxièmes segments de connexion (212) adjacents, dans laquelle les premiers segments de connexion (211) traversent par brûlage la couche de passivation (14) et sont reliés électriquement à la région dopée (12), et les deuxièmes segments de connexion (212) ne traversent pas par brûlage la couche de passivation (14) ; et
une largeur de chacun des deuxièmes segments de connexion (212) est supérieure à une largeur de chacun des premiers segments de connexion (211) le long de la deuxième direction (B) **caractérisée en ce que**
une deuxième région de motif (30), dans laquelle la deuxième région de motif (30) est disposée au niveau de la couche de passivation (14) et est disposée adjacente à la première région de motif (20) le long de la deuxième direction (B), dans laquelle
la deuxième région de motif (30) comprend une pluralité de deuxièmes doigts (31) s'étendant le long de la première direction (A) et disposés à intervalles le long de la deuxième direction (B), la deuxième région de motif (30) comprend en outre des segments collecteurs (32), et les segments collecteurs (32) s'étendent le long de la deuxième direction (B), dans laquelle
une partie des deuxièmes doigts (31) est reliée aux segments collecteurs (32).

2. Cellule solaire selon la revendication 1, dans laquelle une longueur de chacun des premiers segments de connexion (211) est supérieure à une longueur de chacun des deuxièmes segments de connexion (212) le long de la première direction (A).

3. Cellule solaire selon la revendication 1, dans laquelle une polarité de chacun des deuxièmes segments de connexion (212) est opposée à une polarité d'un premier segment de connexion (211) adjacent le long de la deuxième direction (B).

4. Cellule solaire selon la revendication 3, dans laquelle la cellule solaire comprend en outre une couche isolante (40), dans laquelle
la couche isolante (40) comprend une pluralité de bandes isolantes (41) s'étendant le long de la première direction (A) et disposées à intervalles le long de la deuxième direction (B), et chacune des bandes isolantes (41) recouvre une partie qui appartient à l'un des premiers segments de connexion (211) et qui est située entre deux deuxièmes segments de connexion (212) adjacents.

5. Cellule solaire selon la revendication 4, dans laquelle, le long de la deuxième direction (B), une distance entre un bord latéral qui appartient à chacun des deuxièmes segments de connexion (212) et qui est proche d'une bande isolante (41) adjacente et un bord latéral qui appartient à la bande isolante (41) adjacente et qui est proche du deuxième segment de connexion (212) est d4, et d4≥40 µm est satisfaite.

6. Cellule solaire selon la revendication 3, dans laquelle chacun des premiers segments de connexion (211) présente une première projection et chacun des deuxièmes segments de connexion (212) présente une deuxième projection dans un plan dans lequel est situé le corps de cellule solaire (10), et la première projection se trouve au moins partiellement à l'intérieur de la deuxième projection ; et
une distance entre deux premiers doigts (21) adjacents ayant une même polarité le long de la deuxième direction (B) est P1, une distance selon laquelle deux premiers segments de connexion (211) reliés à un même deuxième segment de connexion (212) sont séparés le long de la première direction (A) est P2, et P2≤P1 est satisfaite.

7. Cellule solaire selon la revendication 6, dans laquelle une longueur des deuxièmes segments de connexion (212) le long de la première direction (A) est P3, et P2<P3 est satisfaite ; et/ou
P2>0 mm, et 0,5 mm≤P1≤1,5 mm.

8. Module photovoltaïque, comprenant :
une cellule solaire selon la revendication 1 ; et
des connecteurs électriques (50), dans lequel les connecteurs électriques (50) s'étendent le long de la deuxième direction (B), les connecteurs électriques (50) sont reliés électriquement aux deuxièmes segments de connexion (212), et les connecteurs électriques (50) sont isolés des premiers segments de connexion (211) ; et
des régions de chevauchement existent entre des portions d'extrémité des connecteurs électriques (50) et des projections des segments collecteurs (32) sur le corps de cellule solaire (10).

9. Module photovoltaïque selon la revendication 8, dans lequel les connecteurs électriques (50) sont isolés des premiers segments de connexion (211) au moyen d'une couche isolante (40) ; et
la couche isolante (40) comprend une pluralité de bandes isolantes (41) disposées à intervalles le long de la deuxième direction (B), et chacune des bandes isolantes (41) est disposée entre l'un des premiers segments de connexion (211) et l'un des connecteurs électriques (50).

10. Module photovoltaïque selon la revendication 9, dans lequel le module photovoltaïque comprend en outre une première couche d'engagement (60), dans laquelle
la première couche d'engagement (60) comprend une pluralité de premières portions d'engagement (61) disposées à intervalles le long de la deuxième direction (B), et chacune des premières portions d'engagement (61) est disposée entre l'un des deuxièmes segments de connexion (212) et l'un des connecteurs électriques (50) ; et/ou
une hauteur des premières portions d'engagement (61) est supérieure à une hauteur des bandes isolantes (41) le long d'une direction d'épaisseur du module photovoltaïque.

11. Module photovoltaïque selon la revendication 10, dans lequel, le long de la première direction (A), une longueur des bandes isolantes (41) est supérieure à une longueur des premières portions d'engagement (61) ; et/ou
la longueur des bandes isolantes (41) et la longueur des premières portions d'engagement (61) sont toutes deux supérieures à une largeur des connecteurs électriques (50).

12. Module photovoltaïque selon la revendication 9, dans lequel une hauteur de régions médianes des bandes isolantes (41) est supérieure à une hauteur de régions des deux côtés des bandes isolantes (41) le long de la deuxième direction (B).

13. Module photovoltaïque selon la revendication 8, dans lequel un rapport d'une longueur des régions de chevauchement à une longueur des segments collecteurs (32) le long de la deuxième direction (B) est supérieur ou égal à 0,1 et inférieur ou égal à 0,5.
